# FASCICULE DE BREVET EUROPEEN

(11) **EP 3 352 312 B1**
(45) Date de publication et mention de la délivrance du brevet: **13.11.2019**
(21) Numéro de dépôt: 18152261.6
(22) Date de dépôt: 18.01.2018
(51) Int. Cl.: H01S 5/02, H01S 5/026, H01S 5/10, H01S 5/125, H01S 5/30, H01S 5/042, H01S 5/12

(54) **DISPOSITIF PHOTONIQUE COMPORTANT UN LASER OPTIQUEMENT CONNECTÉ À UN GUIDE D'ONDE SILICIUM ET PROCÉDÉ DE FABRICATION D'UN TEL DISPOSITIF PHOTONIQUE**
PHOTONISCHE VORRICHTUNG, DIE EINEN LASER UMFASST, DER OPTISCH MIT EINEM SILIZIUM-WELLENLEITER VERBUNDEN IST, UND HERSTELLUNGSVERFAHREN EINER SOLCHEN PHOTONISCHEN VORRICHTUNG
PHOTONIC DEVICE INCLUDING A LASER OPTICALLY CONNECTED TO A SILICON WAVEGUIDE AND METHOD FOR MANUFACTURING SUCH A PHOTONIC DEVICE

(30) Priorité: 19.01.2017 FR 1750441
(43) Date de publication de la demande: 25.07.2018
(73) Titulaire: Commissariat à l'énergie atomique et aux énergies alternatives, 75015 Paris (FR)
(72) Inventeur: MENEZO, Sylvie, 38500 VOIRON (FR); THIESSEN, Torrey Lane, TORONTO, Ontario M5R 2K2 (CA); POON, Joyce Kai See, TORONTO, Ontario M4Y 2X6 (CA)
(74) Mandataire: Brevalex

(56) Documents cités:
- EP-A1- 2 988 378
- KEYVANINIA S ET AL: "Heterogeneously integrated III-V/silicon distributed feedback lasers", OPTICS LETTERS, OPTICAL SOCIETY OF AMERICA, vol. 38, no. 24, 15 décembre 2013 (2013-12-15), pages 5434-5437, XP001587456, ISSN: 0146-9592, DOI: 10.1364/OL.38.005434 [extrait le 2013-12-12]
- DUPREZ HELENE ET AL: "Hybrid III-V on Silicon Laterally Coupled Distributed Feedback Laser Operating in the $O$ -Band", IEEE PHOTONICS TECHNOLOGY LETTERS, IEEE SERVICE CENTER, PISCATAWAY, NJ, US, vol. 28, no. 18, 15 septembre 2016 (2016-09-15), pages 1920-1923, XP011615748, ISSN: 1041-1135, DOI: 10.1109/LPT.2016.2576021 [extrait le 2016-07-01]

## Description

### DOMAINE TECHNIQUE

L'invention concerne le domaine de l'optoélectronique et des dispositifs de la photonique.

L'invention a plus précisément pour objet un dispositif photonique comportant un guide d'onde silicium destiné à accommoder plusieurs composants photoniques silicium et un laser hybride sur silicium comprenant un milieu à gain apte à émettre de la lumière

### ÉTAT DE LA TECHNIQUE ANTÉRIEURE

La fabrication de dispositifs photoniques hybrides intégrant des composants photoniques silicium et au moins un laser hybride sur silicium comprenant un milieu à gain apte à émettre de la lumière, tels qu'un milieu à gain réalisé en matériaux semi-conducteurs III-V, doit nécessairement prendre en compte les contraintes de conceptions en ce qui concerne le dimensionnement du premier guide d'onde en silicium accommodant les composants photoniques Silicium et du deuxième guide d'onde en silicium rentrant dans la composition du laser hybride. Un tel laser hybride comprend généralement :
- une structure à gain comportant au moins un milieu à gain apte à émettre de la lumière, la structure à gain étant sus-jacente à une section du deuxième guide d'onde silicium pour former avec celui-ci un guide d'onde hybride,
- une structure de contre réaction optique permettant de former une cavité oscillante comprenant le milieu à gain de ladite structure à gain,
- et des transitions optiques entre le deuxième guide d'onde Silicium et le guide d'onde hybride.

On entend ci-dessus et dans le reste de ce document par « structure à gain », une structure à matériaux semi-conducteurs adaptée pour fournir une émission de lumière pouvant être notamment stimulée afin de fournir une émission du type laser lorsqu'une telle structure est couplée à une structure de contre réaction optique, telle qu'un réseau de Bragg distribué le long de ladite structure à gain. Une telle structure à gain comporte au moins un milieu à gain, qui est le matériau dans lequel l'émission de lumière est générée, et, de part et d'autre, une première et deuxième zone présentant chacune un type de conductivité opposé à celui de l'autre pour autoriser un pompage électrique du milieu à gain. Dans une application classique de lasers à matériaux semi-conducteurs, notamment pour fournir une émission dans les gammes de longueurs d'onde de l'infrarouge et en particulier aux longueurs d'onde 1310nm et 1550nm, les première et deuxième zones et le milieu à gain sont formés par croissance épitaxiale sur des substrats en phosphure d'indium InP ou en arséniure de gallium GaAs. En effet, la faible différence de maille de ces matériaux avec leurs alliages quaternaires permet de fournir des première et deuxième zones et un milieu à gain de bonne qualité cristalline idéals pour optimiser le rendement d'émission laser.

Le milieu à gain d'une telle structure à gain peut comporter une succession de puits quantiques fournissant l'émission de lumière. Afin d'augmenter le facteur de confinement du mode optique dans les puits quantiques, ceux-ci sont généralement encadrés par deux couches de barrière. En alternative aux puits quantiques, le milieu à gain peut également comporter des boîtes quantiques. Afin de former de tels puits quantiques, ou boîtes quantiques, et dans une configuration classique d'un tel laser hybride, le milieu à gain peut comporter au moins deux matériaux semi-conducteurs sélectionnés par exemple dans le groupe comportant le phosphure d'indium InP, l'arséniure de gallium GaAs, l'arséniure d'indium InAs, l'arséniure-phosphure de gallium-indium InGaAsP, l'arséniure de gallium-indium-aluminium InGaAIAs, l'arséniure d'aluminium-gallium AIGaAs et l'arséniure-phosphure d'indium InAsP et leurs alliages. De la même façon, la première et la deuxième zone peuvent être réalisées dans au moins un matériau semi-conducteur sélecté dans le groupe comportant le phosphure d'indium InP, l'arséniure de gallium GaAs, l'arséniure d'indium InAs, l'arséniure-phosphure de gallium-indium InGaAsP, l'arséniure de gallium-indium-aluminium InGaAlAs, l'arséniure-nitrure d'aluminium-indium InGaAsN, l'arséniure d'aluminium-gallium AIGaAs et l'arséniure-phosphure d'indium InAsP et leurs alliages, l'une de la première et la deuxième zone étant d'un premier type de conductivité dans lequel les porteurs majoritaires sont les électrons, l'autre étant d'un deuxième type de conductivité dans lequel les porteurs majoritaires sont les trous.

De telles structures à gain peuvent être soit du type « vertical » soit du type « latéral». Dans le premier cas, c'est-à-dire une structure à gain du type « vertical », la première zone, le milieu à gain et la deuxième zone sont constituées par un empilement de couches à la surface d'un support. Dans une telle configuration, L'épaisseur de l'empilement formant structure à gain est généralement comprise entre 1 à 3 µm. Dans le second cas, c'est-à-dire une structure à gain du type « latéral », la première zone, le milieu à gain, et la deuxième zone se succède en contact le long d'un support. L'épaisseur typique d'une structure à gain du type latéral est de l'ordre de 500 nm.

On entend ci-dessus et dans le reste de ce document par « structure de contre réaction optique », une structure optique réalisée dans un guide d'onde et permettant de former une cavité oscillante guidante comprenant le milieu à gain. Ainsi, le champ optique effectue des allers/retours dans le guide d'onde de la cavité entre les extrémités de cette même cavité oscillante ceci pour générer une émission stimulée du milieu à gain.

Dans le cas d'un laser dit laser à contre réaction répartie (ou Distributed Feedback Laser en anglais - connu sous l'acronyme laser DFB), la structure de contre réaction optique est constituée par un réflecteur distribué, tel qu'un réseau de Bragg, sous ou dans la structure à gain, formant un miroir sélectif en longueur d'onde.

Dans le cas d'un laser dit à réseau de Bragg distribué (ou Distributed Bragg Reflector Laser en anglais - connu sous l'acronyme laser DBR), la structure de contre réaction est constituée de réflecteurs disposés dans le guide d'onde, de part et d'autres de la structure à gain.

Ainsi, dans un tel dispositif photonique, le premier guide d'onde en silicium accommode les composants photoniques silicium, tels que des composants passifs (par exemple et de manière non limitative des réseaux de couplage surfaciques, des multiplexeur/démultiplexeur optique de type réseau de guides d'onde (connu sous le sigle anglais AWG) ou à réseau échelle, des anneaux résonants) et tels que des composants actifs (par exemple, et de manière on limitative, des modulateurs formés par des dopages P et N du guide d'onde Silicium). Ces composants, qui sont accommodés dans le premier guide d'onde, nécessitent une épaisseur de guide d'onde relativement réduite, généralement de l'ordre de 220 nm à 300 nm. Ceci est notamment le cas pour les modulateurs, pour qu'ils présentent une bande passante optimisée, et pour les anneaux résonants, pour qu'ils présentent une longueur d'onde de résonance peu dispersée.

Par contre, l'intégration du laser hybride nécessite d'utiliser un second guide d'onde silicium d'épaisseur plus importante, généralement supérieure ou égale à 500 nm. Une information plus complète concernant ces contraintes d'intégration d'un laser hybride dans un tel dispositif photonique est notamment fournie par Po Dong *et al.* dans leurs travaux publiés dans la revue scientifique « Optics Express » Vol. 22 n° 22 en novembre 2014 pages 26861 à 26868. De plus, le premier et le deuxième guide d'onde étant d'épaisseur différente, un tel dispositif comprend nécessairement des transitions entre le premier guide d'onde en silicium et le second guide d'onde en silicium.

Afin de répondre à ces contraintes de conception, différents procédés de fabrication et dispositifs photoniques ont été proposés.

Un premier procédé de fabrication décrit par Duprez H.et ses co-auteurs dans la revue scientifique « IEEE Photonics Technology Letters » Vol.28 N°18 pages 1920 - 1923 en septembre 2016, comporte les étapes suivantes :
- fourniture d'un substrat associé avec une couche de silicium sur une première couche diélectrique, la couche de silicium présentant une épaisseur de 500 nm,
- un étape d'amincissement partiel de la couche de silicium pour former une première et une deuxième zone dans lesquelles les épaisseurs de silicium sont respectivement 300 nm et 500 nm, et plusieurs étapes de structuration du silicium pour former dans la première zone un premier guide d'onde silicium de 300 nm d'épaisseur, ledit guide d'onde accommodant un réseau de couplage surfacique (indiqué « grating to fiber coupler» par les coauteurs), et dans la deuxième zone d'épaisseur 500 nm, les parties en silicium composant le laser hybride sur silicium, et plus particulièrement, le deuxième guide d'onde silicium, la structure de contre réaction optique (réseau de Bragg distribué accommodé dans une section du deuxième guide d'onde destinée à être sous-jacente à la structure à gain), ainsi que les zones de transition optique du guide d'onde hybride laser,

- encapsulation de la couche de silicium partiellement amincie et structurée par un matériau diélectrique et planarisation pour former une deuxième couche diélectrique plane,
- formation d'une structure à gain au niveau du second guide d'onde silicium en contact avec la deuxième couche diélectrique, une telle formation permettant de former le guide d'onde hybride laser comportant notamment une partie de la structure à gain et la structure de contre action optique.

Un tel procédé permet donc de fournir un dispositif photonique hybride comportant un premier guide d'onde présentant une épaisseur de 300 nm et pouvant donc accommoder des composants silicium optimisés tout en comportant, au moyen de la deuxième zone d'épaisseur de 500 nm, un laser hybride également optimisé. Néanmoins, un tel procédé de fabrication et le dispositif photonique qu'il permet de fabriquer présentent un certain nombre d'inconvénients.

En effet, un tel procédé de fabrication fait appel à une étape de gravure pour amincir de façon localisée la première couche de silicium afin de former le premier guide d'onde avec une épaisseur de 300 nm. Il résulte d'un tel amincissement que le premier guide d'onde présente une rugosité importante, qui a pour conséquence des pertes optiques relativement importantes. Par ailleurs, l'épaisseur du premier guide d'onde présente une dispersion significative qui peut dégrader le fonctionnement des composants qui y sont accommodés (notamment une dispersion augmentée de la longueur d'onde centrale de filtres de type anneaux résonants ou de multiplexeurs/démultiplixeurs AWGs, ou à réseaux échelle). De plus, en raison de la nécessité d'encapsuler les premier et deuxième zones dans un matériau diélectrique, la deuxième zone présentant une épaisseur supérieure de 200 nm à celle de la première zone, et de la nécessité de planariser ce même matériau diélectrique pour former la deuxième couche diélectrique, l'épaisseur de la deuxième couche diélectrique est mal contrôlée et présente une dispersion supérieure ou égale à ±20 nm. Il en résulte que la structure à gain et la deuxième zone, qui accommode notamment la structure de contre réaction optique, sont séparées l'une de l'autre par une épaisseur de diélectrique supérieure ou égale à 50 nm ±20 nm voire à 75 nm. Il en résulte un mauvais contrôle du confinement du mode optique dans le milieu à gain et du pouvoir réfléchissant de la structure de contre réaction optique.

De plus, la section du second guide d'onde en silicium sous-jacente à la structure à gain, et qui accommode notamment la structure de contre réaction optique, présente une épaisseur de 500 nm. Il en résulte que le mode optique dans le guide d'onde hybride laser est tiré vers la couche de silicium et donc, de ce fait, que le confinement du mode optique dans le milieu à gain est moindre. Le rendement de l'émission laser n'est donc pas optimisé.

Un deuxième procédé est décrit par Po Dong et al. dans leurs travaux publiés dans la revue scientifique « Optics Express » Vol. 22 n° 22 en novembre 2014 pages 26861 à 26868 et par Ferrotti T. et al. dans la revue scientifique « IEEE Photonics Technology Letters » Vol.28 N°18 pages 1944 à 1947.

Ce procédé comporte les étapes suivantes :
- fourniture d'un substrat associé avec une première couche de silicium de 300 nm sur une première couche diélectrique, la première couche de silicium présentant ainsi l'épaisseur du premier guide d'onde,
- structuration de la première couche de silicium pour former le premier guide d'onde et une section de guide d'onde distincte du premier guide d'onde, le premier guide d'onde accommodant un réseau de couplage surfacique,
- formation d'une surépaisseur de silicium accommodant la structure de contre réaction optique par dépôt d'une deuxième couche de silicium recouvrant au moins partiellement la première couche de silicium structurée, l'épaisseur cumulée de la surépaisseur de silicium et la première couche de silicium étant égale à 500 nm afin de permettre la formation du second guide d'onde optique dont une section est destinée à être sous la structure à gain et à former le guide d'onde hybride et les zones de transitions avec cette dernière,

- encapsulation de la première couche de silicium structurée et de la surépaisseur, associée de la structure de contre réaction optique qu'elle accommode, par un matériau diélectrique et formation d'une deuxième couche diélectrique,
- formation d'une structure à gain, comportant au moins un milieu à gain en semi-conducteur III-V, la structure à gain étant en contact avec la deuxième couche diélectrique.

On notera que les travaux de Po Dong *et al.* et de Ferrotti T. *et al.* se distinguent en ce qu'ils utilisent respectivement du silicium mono-cristallin déposé en contact avec la première couche de silicium et une couche de silicium amorphe déposée en contact avec une couche d'oxyde.

Néanmoins, avec un tel procédé, la qualité du silicium formant la surépaisseur, que ce soit avec le silicium mono-cristallin épitaxié sélectivement sur la première couche de silicium ou avec le silicium amorphe, est relativement faible vis-à-vis notamment à celle fournie par une couche de silicium sur isolant. Ainsi, les pertes de guides d'onde réalisés dans un tel silicium (épitaxié ou déposé) sont donc relativement importante, en comparaison avec celle d'un guide d'onde formé dans une couche de silicium sur isolant. Ainsi, avec un tel procédé, le guide d'onde hybride laser est réalisé dans un silicium de qualité relativement faible et les pertes optiques dans le guide d'onde hybride sont augmentées vis-à-vis d'un dispositif photonique selon le premier procédé décrit ci-dessus. De la même façon que pour le premier procédé de fabrication, l'épaisseur de la deuxième couche diélectrique, qui sépare le guide d'onde, et notamment la structure de contre réaction optique qui y est accommodée, de la structure à gain, est mal contrôlée et présente une dispersion supérieure ou égale à ±20 nm. Il en résulte que la structure à gain et la deuxième zone, associée à la structure de contre réaction optique, sont séparées l'une de l'autre par une épaisseur de diélectrique supérieure ou égale à 50 nm ±20 nm, voire à 75 nm ±50 nm. Cela conduit à un mauvais contrôle du confinement du mode optique dans le milieu à gain et du pouvoir réfléchissant de la structure de contre réaction optique.

De plus et de manière identique au premier procédé décrit ci-dessus, la section du second guide d'onde en silicium sous-jacente à la structure à gain, et qui accommode notamment la structure de contre réaction optique, présente une épaisseur de 500 nm. Il en résulte que le mode optique dans le guide d'onde hybride laser est tiré vers la couche de silicium et donc, de ce fait, le confinement du mode optique dans le milieu à gain est moindre. Le rendement de l'émission laser n'est donc pas optimisé.

Un troisième procédé, décrit notamment dans le document EP2988378, comporte les étapes suivantes :
- fourniture d'un substrat associé avec une couche de silicium (indiquée SOI) sur une première couche diélectrique (indiquée BOX), la couche de silicium (SOI) présentant une épaisseur de 500 nm,
- structuration de la couche de silicium pour mettre en forme le premier et le deuxième guide d'onde silicium sur une partie de l'épaisseur de la couche de silicium, le reste de l'épaisseur étant conservé, la structuration de la couche de silicium étant adaptée pour former, dans le deuxième guide d'onde, les zones de transition optique et la section de guide d'onde destinée à être sous-jacente à la structure à gain,
- encapsulation de la couche de silicium structurée par un matériau diélectrique et planarisation pour former une deuxième couche diélectrique,
- report de l'ensemble substrat/ couche de silicium/ deuxième couche diélectrique sur un support et suppression du substrat et de la première couche diélectrique (BOX),
- amincissement localisé dans une première zone de la couche de silicium afin d'amincir le premier guide d'onde à une épaisseur de 300nm, le second guide d'onde conservant une épaisseur de 500 nm
- structuration du second guide d'onde pour former la structure de contre réaction optique accommodée dans la section de guide d'onde destinée à être sous-jacente à la structure à gain,
- encapsulation de la couche de silicium dans une troisième couche diélectrique,
- formation d'une structure à gain en contact avec la troisième couche diélectrique, la structure à gain formant, avec la section du second guide d'onde silicium qui lui est sous-jacente, le guide d'onde hybride laser, le laser étant ainsi formé par la structure à gain, la structure de contre réaction et les zones de transition optique et le dispositif photonique étant formé par le laser et le premier guide d'onde silicium.

Un tel procédé fait appel à plusieurs étapes de gravure et d'encapsulation de la couche de silicium qui sont préjudiciables pour la précision de l'épaisseur du premier guide d'onde, ceci en y générant des pertes, et donc pour les performances optiques des composants silicium accommodés dans le premier guide d'onde. De la même façon, comme les premier et deuxième procédés décrits ci-dessus, avec un tel procédé de fabrication l'épaisseur de la couche diélectrique qui sépare le guide d'onde de la structure à gain est mal contrôlée, la couche diélectrique présentant ainsi une dispersion supérieure ±20 nm. Il en résulte que la structure à gain et la deuxième zone, qui accommode notamment la structure de contre réaction optique, sont séparées l'une de l'autre par une épaisseur de diélectrique supérieure ou égale à 50 nm ±20 nm, voire à 75 nm ±50 nm. Il en résulte un mauvais contrôle du confinement du mode optique dans le milieu à gain et du pouvoir réfléchissant de la structure de contre réaction optique.

De plus et de manière identique au premier et au deuxième procédé décrit ci-dessus, la section du second guide d'onde en silicium sous-jacente à la structure à gain, et qui accommode notamment la structure de contre réaction optique, présente une épaisseur de 500 nm. Il en résulte que le mode optique dans le guide d'onde hybride laser est tiré vers la couche de silicium et donc, de ce fait, le confinement du mode optique dans le milieu à gain est moindre. Le rendement de l'émission laser n'est donc pas optimisé.

Un autre procédé d'intégration III/V sur Silicium est divulgué dans l'article de S.Keyvaninia intitulé "Heterogeneously integrated III-V/silicon distributed feedback lasers", Optics Letters, vol. 38, no. 24, 15 décembre 2013, pages 5434-5437.

### EXPOSÉ DE L'INVENTION

L'invention vise à remédier au moins l'un de ces inconvénients et a ainsi pour but de fournir un dispositif photonique comportant un laser présentant un confinement optique dans le milieu à gain optimisé et des pertes réduites vis-à-vis des lasers des dispositifs optiques de l'art antérieur.

L'invention concerne à cet effet un dispositif photonique comportant :
- un support,
- une couche intermédiaire en contact avec le support et comportant au moins un matériau diélectrique et une première et une deuxième surépaisseur de silicium, la première et la deuxième surépaisseur de silicium étant séparées l'une de l'autre par un espace,
- une première couche de silicium en contact avec la couche intermédiaire à l'opposé du support, la première couche de silicium comportant au moins une partie de l'épaisseur d'un guide d'onde, et une première à une cinquième section de guide d'onde distinctes du guide d'onde, la première à la cinquième section de guide d'onde se succédant et étant connectées optiquement au guide d'onde par au moins l'une de la première et de la cinquième section de guide d'onde, la deuxième, la quatrième et la troisième section de guide d'onde étant en regard de respectivement la première et la deuxième surépaisseur et de l'espace,
- une première couche de diélectrique recouvrant la première couche de silicium à l'opposé de à la couche intermédiaire,
- une structure à gain comportant au moins un milieu à gain apte à émettre de la lumière, la structure à gain présentant une portion centrale en regard de l'espace et une première et une deuxième extrémité en regard de la première et la deuxième surépaisseur, ainsi, la portion centrale de la structure à gain forme avec l'espace et la troisième section de guide d'onde un guide d'onde hybride laser, les deuxième et quatrième section de guide d'onde, les première et deuxième surépaisseurs de silicium, et les première et deuxième extrémités de la structure à gain formant une première et une deuxième zone de transition optique d'un mode optique entre le guide d'onde hybride laser et respectivement la première et la cinquième section de guide d'onde,
- une structure de contre réaction pour former une cavité oscillante comprenant au moins une partie du milieu à gain de manière à former un laser connecté optiquement au guide d'onde par au moins l'une de la première et la cinquième section de guide d'onde.

Avec un tel dispositif photonique, la transition optique entre les première et cinquième sections de guide d'onde et le guide d'onde hybride laser est obtenue sans faire appel à une surépaisseur sur toute la longueur de la structure à gain. Il en résulte que la connexion optique entre le laser et le guide d'onde ne se fait pas au détriment d'une baisse significative du confinement optique dans le milieu à gain. En effet, la couche de silicium sous la structure à gain, en dehors des zones de transition, présente une épaisseur relativement faible, correspondant à celle du guide d'onde silicium. Le rendement d'émission du laser se trouve donc amélioré vis-à-vis des dispositifs photoniques de l'art antérieur qui ne présente pas un tel confinement optimisé.

De plus, les zones de transition optique présentes aux niveaux des deux extrémités de la structure à gain permettent de fournir une transition optique de l'émission laser vers le guide d'onde de manière sensiblement identique à celle de l'art antérieur. Ainsi, la première et la deuxième zone de transition optique fournissent une transition adiabatique du mode optique entre le guide d'onde hybride laser et respectivement la première et la cinquième section de guide d'onde. Le dispositif photonique présente donc ainsi un confinement optique optimisé sans que cela n'affecte significativement la transition de l'émission laser vers le guide d'onde silicium d'épaisseur réduite.

La troisième section de guide d'onde peut accommoder un réflecteur distribué formant la structure de contre réaction.

Le réflecteur distribué peut être un réseau de Bragg distribué sélectionné dans le groupe comportant les réseaux de Bragg distribués à corrugations latérales partiellement gravées dans une épaisseur de la première couche de silicium, les réseaux de Bragg distribués à corrugations latérales totalement gravées dans l'épaisseur de la première couche de silicium, les réseaux de Bragg distribués à corrugations verticales partiellement gravées dans l'épaisseur de la première couche de silicium et les réseaux de Bragg distribués à corrugations verticales totalement gravées dans l'épaisseur de la première couche de silicium.

Avec de tels réseaux de Bragg distribués accommodés dans la troisième section de guide d'onde, le laser est un laser du type laser à rétroaction répartie également connu sous la dénomination anglaise « Distributed FeedBack laser » et le sigle correspondant laser DFB. Il bénéficie particulièrement du confinement amélioré du milieu à gain apporté par l'invention.

Afin de fournir une opération monomode longitudinale du laser, le dispositif peut comporter l'une des deux caractéristiques suivantes :
- le réseau de Bragg distribué comprend un saut de phase de type quart d'onde.
- l'une de la première et la cinquième section de guide d'onde accommode un réflecteur sensiblement total, le réflecteur total pouvant être sélectionné parmi les réflecteurs de type Sagnac, les réseaux de Bragg distribué, les miroirs du type facette avec traitement haute réflectivité, le premier guide d'onde étant connecté uniquement à l'autre parmi la première et la cinquième section de guide d'onde.

De cette manière, le laser possède une émission parfaitement monomode longitudinale.

La première couche diélectrique peut présenter une épaisseur inférieure ou égale à 75 nm.

Le réflecteur distribué peut être sélectionné dans le groupe comportant les réseaux de Bragg distribués à corrugations latérales partiellement gravées dans une épaisseur de la première couche de silicium et les réseaux de Bragg distribués à corrugations verticales partiellement gravées dans l'épaisseur de la première couche de silicium,
et la partie de l'épaisseur de la première couche de silicium dans laquelle les corrugations sont gravées étant la partie de l'épaisseur de la première couche de silicium qui est opposée à la première couche diélectrique et à la structure à gain.

La première couche diélectrique peut présenter une épaisseur inférieure ou égale à 50 nm, voire inférieure ou égale à 30 nm.

La première et la cinquième section de guide d'onde peuvent accommoder respectivement un premier et un deuxième miroir de manière à former une cavité oscillante comportant le milieu à gain, le premier et deuxième miroir formant une structure de contre réaction.

Chacun du premier et du deuxième miroir peuvent être sélectionné dans le groupe comportant les miroirs de type Sagnac, les miroirs de type à facette, les réseaux de Bragg distribués.

La deuxième et la quatrième section de guide d'onde peuvent accommoder respectivement un premier et deuxième réseau de Bragg distribués de manière à former une cavité oscillante comportant le milieu à gain, le premier et deuxième réseau de Bragg distribués formant une structure de contre réaction.

La première et la deuxième surépaisseur accommodent respectivement un premier et deuxième réseau de Bragg distribués de manière à former une cavité oscillante comportant le milieu à gain, le premier et deuxième réseau de Bragg distribués formant la structure de contre réaction.

De cette manière, les premier et deuxième miroirs ou réseaux de Bragg délimitent une cavité oscillante comportant le milieu à gain de la structure à gain ceci avec un confinement optimisé, le mode optique n'étant pas tiré vers la troisième section de guide d'onde qui présente une épaisseur relativement faible.

La structure à gain est choisie dans le groupe comportant les structures à gain du type à « jonction verticale » et les structures à gain du type à « jonction latérale ».

Ces deux types de structure à gain bénéficient tous deux de l'avantage de l'invention. On notera que cela est particulièrement le cas pour une structure à gain à « jonction latérale », connue pour sa faible épaisseur généralement inférieure à 500 nm, puisqu'il est possible d'utiliser pour former la troisième section de guide d'onde une première couche de silicium fine, et donc, de maximiser la quantité d'énergie du mode optique confinée dans le milieu à gain, sans que la transition optique n'en pâtisse.

L'aménagement du guide d'onde peut être choisi parmi:
- un aménagement du guide d'onde en totalité dans la première couche de silicium,
- un aménagement d'une première partie de l'épaisseur du guide d'onde dans la première couche de silicium et d'une deuxième partie de l'épaisseur du guide d'onde dans une troisième surépaisseur de silicium,
- un aménagement d'une première partie de l'épaisseur du guide d'onde dans la première couche de silicium et d'une deuxième partie de l'épaisseur du guide d'onde dans une cinquième surépaisseur réalisée dans un matériau de la structure à gain,
- une combinaison d'au moins deux des aménagements précités.

Le premier guide d'onde peut accommoder au moins un composant optique, le composant optique étant préférentiellement choisi dans le groupe comportant les modulateurs optiques silicium à jonction PN, les modulateurs hybrides semi-conducteur III-V sur silicium, les réseaux de couplage surfaciques, les coupleurs par la tranche, les filtres optiques, les multiplexeurs et démultiplexeurs en longueurs d'onde, et les photodétecteurs dont font partie les photodétecteur germanium sur silicium et les photodétecteurs semi-conducteur III-V sur silicium.

La première couche diélectrique peut présenter une épaisseur inférieure ou égale à 30 nm.

La première couche de silicium peut présenter une épaisseur inférieure ou égale à 300 nm, celle-ci étant préférentiellement égale à 300 nm.

La première couche diélectrique et la première couche de silicium peuvent être respectivement une couche isolante et une couche de silicium d'un substrat du type silicium sur isolant.

La première et la deuxième surépaisseur de silicium sont chacune réalisées en un silicium sélectionné parmi un silicium mono-cristallin, un silicium amorphe, et un silicium poly-cristalin.

L'au moins une troisième surépaisseur peut être réalisée dans le même matériau que la première et la deuxième surépaisseur.

Au moins l'une parmi la deuxième section de guide d'onde et la première surépaisseur et l'une parmi la quatrième section de guide d'onde et la deuxième surépaisseur peuvent présenter au niveau de respectivement la première et la deuxième extrémité de la structure à gain une forme fuselée et/ou au moins une extrémitétrapézoïdale.

Au moins l'une parmi la première et les deuxièmes extrémités de la structure à gain peut présenter une forme fuselée et/ou trapézoïdale.

Il peut être prévu un premier et un deuxième contact électrique en contact avec la structure à gain afin de polariser la structure à gain.

L'invention concerne en outre procédé de fabrication d'un dispositif photonique comportant au moins un guide d'onde en silicium et un laser comprenant un milieu à gain apte à émettre de la lumière, le procédé comportant les étapes suivantes :
- fourniture d'un substrat associé avec une première couche de silicium sur une première couche diélectrique,
- structuration de la première couche de silicium pour former dans la première couche de silicium au moins une partie d'épaisseur d'un guide d'onde et des première à cinquième sections de guide d'onde distinctes du guide d'onde, la première à la cinquième section de guide d'onde se succédant et étant connectées optiquement au guide d'onde par au moins l'une de la première et la cinquième section de guide d'onde,
- formation d'une première et d'une deuxième surépaisseur de silicium séparée l'une de l'autre par un espace, la première et la deuxième surépaisseur et l'espace étant en regard de respectivement les deuxième, quatrième et troisième sections de guide d'onde ou de zones de la première couche de silicium destinées à les formées,
- enterrement d'au moins la première et de la deuxième surépaisseur de silicium par au moins un matériau diélectrique et planarisation dudit matériau diélectrique afin de former une couche intermédiaire, un ensemble substrat/ première couche diélectrique/ première couche de silicium/ couche intermédiaire étant ainsi formé,
- fourniture d'un support,
- assemblage de l'ensemble substrat/ première couche diélectrique/ première couche de silicium/ couche intermédiaire sur le support, l'assemblage étant réalisé par collage de la couche intermédiaire sur le support,
- suppression du substrat,
- formation d'une structure à gain comportant au moins le milieu à gain, la structure à gain étant formée en contact avec la première couche diélectrique en présentant une portion centrale de la structure à gain en regard de l'espace et une première et une deuxième extrémité en regard de la première et la deuxième surépaisseur, ainsi, la portion centrale de la structure à gain forme avec l'espace et la troisième section de guide d'onde un guide d'onde hybride laser, les deuxième et quatrième section de guide d'onde, les première et deuxième surépaisseurs de silicium, et les première et deuxième extrémités de la zone active formant une première et une deuxième zone de transition optique d'un mode optique entre le guide d'onde hybride laser et respectivement la première et la cinquième section de guide d'onde, le dispositif photonique étant ainsi formé,
et dans lequel il est en outre formé une structure de contre réaction pour former une cavité oscillante comprenant au moins en partie le milieu à gain et ainsi former un laser connecté optiquement au guide d'onde par au moins l'une de la première et la cinquième section de guide d'onde lors de l'au moins une des étapes parmi l'étape de structuration de la première couche de silicium et de l'étape de formation de la première et de la deuxième surépaisseur de silicium.

Un tel procédé permet la fabrication d'un dispositif bénéficiant des avantages de l'invention.

On notera de plus, qu'avec un tel procédé il est possible de fournir un dispositif photonique présentant une épaisseur de la première couche diélectrique égale ou inférieure à 30 nm avec un contrôle de ±2 nm sur cette épaisseur, non accessible avec les procédés de l'art antérieur.

On notera également, que la première couche de silicium est une couche de silicium sur couche diélectrique, telle que celle fournie par un substrat silicium sur isolant, qui présente de ce fait une qualité cristalline optimale. Ainsi la troisième section de guide d'onde sous-jacente de la structure à gain, et donc avec laquelle la structure à gain interagie, présente une qualité cristalline optimale. Les pertes optiques au niveau du guide d'onde hybride laser s'en trouve donc réduites.

De la même façon, si les avantages indiqués ci-dessus concernent la fabrication individuelle d'un seul dispositif photonique selon l'invention, ces avantages s'appliquent également lors d'un procédé de fabrication selon l'invention dans lequel plusieurs dispositifs photoniques sont fabriqués collectivement par une mise en œuvre parallèle des étapes de fabrication. On notera en particulier, que l'épaisseur de la première couche diélectrique est homogène dans l'ensemble des dispositifs photoniques formés permettant de fournir des performances/caractéristiques relativement homogènes contrairement aux dispositifs photoniques formés avec un procédé de l'art antérieur.

Le procédé de fabrication peut être un procédé de fabrication d'une pluralité de dispositifs photoniques, les étapes du procédé étant mises en œuvre pour former lesdits dispositifs en parallèle.

La structure de contre réaction peut être formée lors de l'étape de structuration de la première couche de silicium, la structuration de la première couche de silicium comprenant en outre la formation d'un réflecteur distribué formant la structure de contre réaction accommodée dans la troisième section de guide d'onde.

Avec un tel réflecteur accommodé dans la troisième section de guide d'onde, le procédé permet la fabrication d'un dispositif photonique comportant un laser du type laser à rétroaction répartie également connu sous la dénomination anglaise « Distributed FeedBack laser» et le sigle correspondant laser DFB. Un tel dispositif photonique fabriqué par un tel procédé de fabrication bénéficie en particulièrement :
- en ce qui concerne le laser, du confinement amélioré dans le milieu à gain apporté par l'invention, de la bonne qualité cristalline de la première couche de silicium, et des faibles pertes optiques qui en découlent, et de l'épaisseur contrôlé de la première couche diélectrique,
- en ce qui concerne le guide d'onde et les composants optiques qui y sont accommodés, l'utilisation d'une première couche de silicium présentant une bonne qualité cristalline et donc de faibles pertes optiques, et d'épaisseur contrôlée, et d'une première couche diélectrique d'épaisseur contrôlée.
la structure de contre réaction peut être formée lors de l'étape de structuration de la première couche de silicium, la structuration de la première couche de silicium comprenant en outre la formation d'un premier miroir accommodé dans l'un parmi la première et la deuxième section de guide d'onde et d'un deuxième miroir accommodé dans l'un parmi la quatrième et la cinquième de guide d'onde, le premier et un deuxième miroir formant ainsi une cavité oscillante comportant le milieu à gain.

La structure de contre réaction peut être formée lors de l'étape de formation de la première et de la deuxième surépaisseur de silicium, la formation de la première et de la deuxième surépaisseur de silicium comprenant en outre la formation d'un premier et d'un deuxième réseau de Bragg accommodés dans respectivement la première et la deuxième surépaisseur de silicium, le premier et un deuxième miroir formant ainsi une cavité oscillante comportant le milieu à gain.

L'étape de structuration de la première couche de silicium peut être préalable à l'étape de formation des première et deuxième surépaisseurs de silicium.

Lors de l'étape de structuration de la première couche de silicium est postérieure à l'étape de suppression du substrat et dans lequel l'étape de structuration de la première couche de silicium est une étape de structuration de la première couche de silicium et de la première couche de diélectrique.

Il peut en outre être prévu une étape d'amincissement de la première couche diélectrique entre les étapes de suppression du substrat et de formation de la structure à gain.

Ainsi la première couche diélectrique présente une épaisseur parfaitement contrôlée, puisqu'elle est issue de l'amincissement d'une couche parfaitement plane.

L'étape de formation de la première et la deuxième surépaisseur de silicium peut être sélectionnée dans le groupe d'étapes de formation suivantes :
- dépôt sélectif de silicium en contact de la première couche de silicium pour former la première et la deuxième surépaisseur de silicium,
- dépôt d'une deuxième couche de silicium et gravure localisée de la deuxième couche de silicium pour former la première et la deuxième surépaisseur de silicium,
- assemblage d'une deuxième couche de silicium sur la première couche de silicium et gravure localisée de la deuxième couche de silicium pour former la première et la deuxième surépaisseur de silicium.

Avec de telles étapes de formation de la première et la deuxième surépaisseur, il est possible de fournir des surépaisseurs en silicium de bonne qualité optique.

Le procédé de fabrication peut comporter en outre l'étape suivante :
- formation d'au moins une troisième surépaisseur de silicium recouvrant des parties de la première couche de silicium structurées ou destinée à être structurées, la troisième section de guide d'onde restant libre de surépaisseur de silicium supplémentaire,
et l'au moins une troisième surépaisseur de silicium peut faire partie du guide d'onde.

De cette manière, il est possible de contrôlé indépendamment l'une l'autre l'épaisseur de la troisième section de guide d'onde et du guide d'onde. Cela est particulièrement avantageux pour un dispositif comprenant une structure à gain à « jonction latérale ».

Lors de l'étape de formation de la structure à gain il peut en outre être formé une zone semi-conductrice dans au moins un matériau semi-conducteur formant la structure à gain en regard avec une portion du premier guide d'onde afin de former un modulateur hybride accommodé dans ledit premier guide d'onde.

### BRÈVE DESCRIPTION DES DESSINS

La présente invention sera mieux comprise à la lecture de la description d'exemples de réalisation, donnés à titre purement indicatif et nullement limitatif, en faisant référence aux dessins annexés sur lesquels :

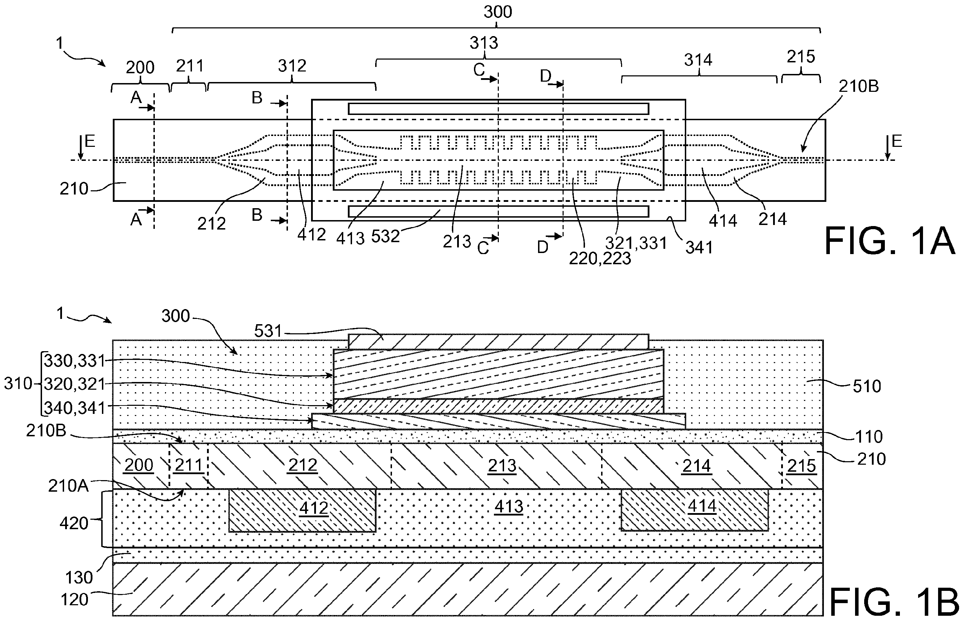

- les figures 1A à 1H illustrent respectivement une vue de dessus simplifiée, une vue en coupe longitudinale selon l'axe EE toutes deux schématiques d'un dispositif photonique selon un premier mode de réalisation de l'invention dans lequel il est prévu un réseau de Bragg distribué sous un milieu à gain, le réseau de Bragg étant du type à « corrugations latérales » partiellement gravées dans une première couche de silicium en tant que structure de contre réaction optique, quatre vues schématiques en coupe selon les axes AA, BB, CC et DD de ce même dispositif photonique et deux vues rapprochées, une de dessus et une en coupe selon l'axe FF, d'une structure à gain du type à « jonction verticale » équipant ledit dispositif photonique,

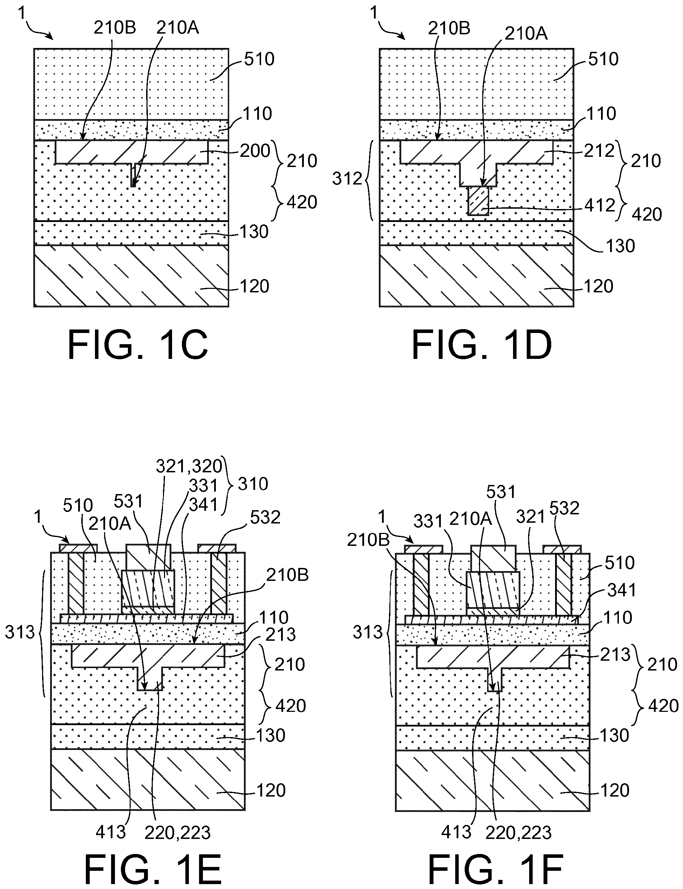

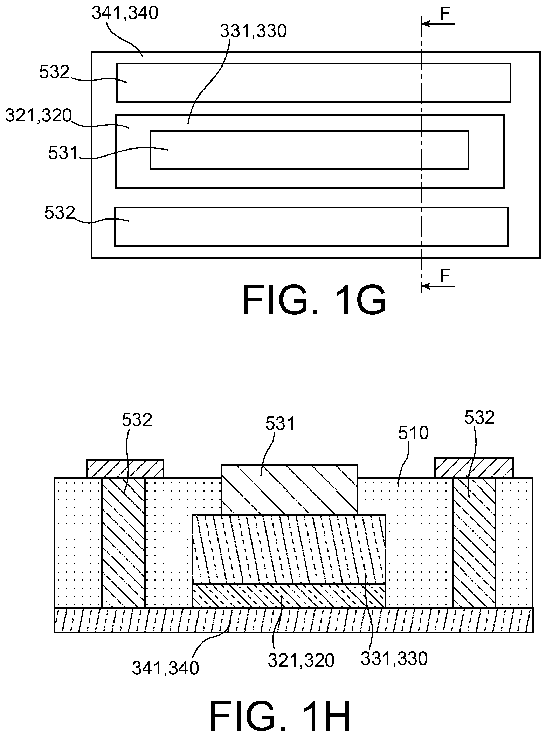

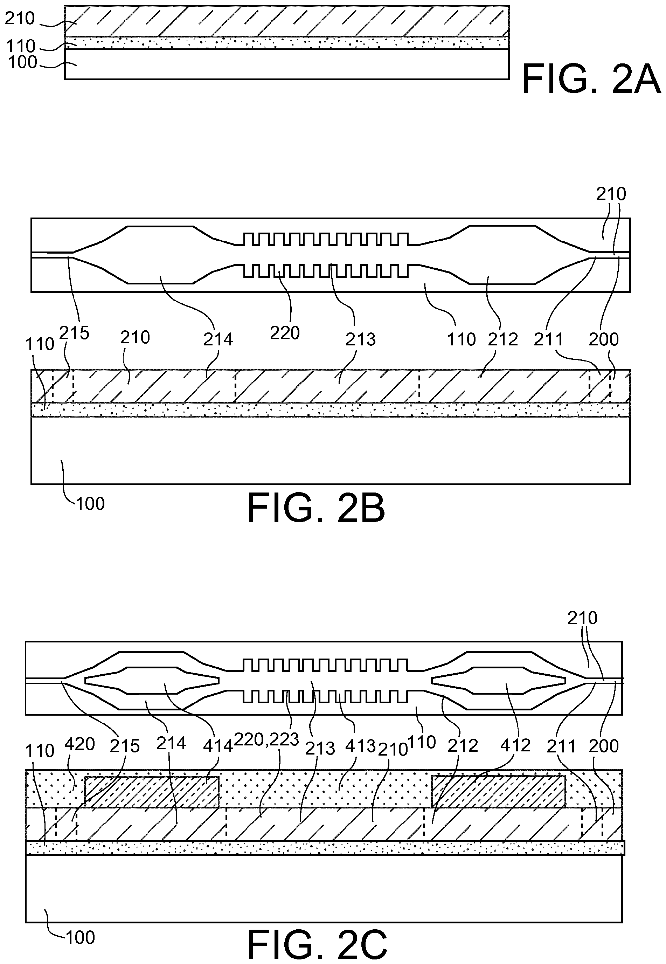

- les figures 2A à 2G illustrent, au moyen de vues de dessus schématiques et en coupe selon l'axe EE tel qu'illustré sur la figure 1A, les principales étapes d'un procédé de fabrication du dispositif photonique illustré sur la figure 1,

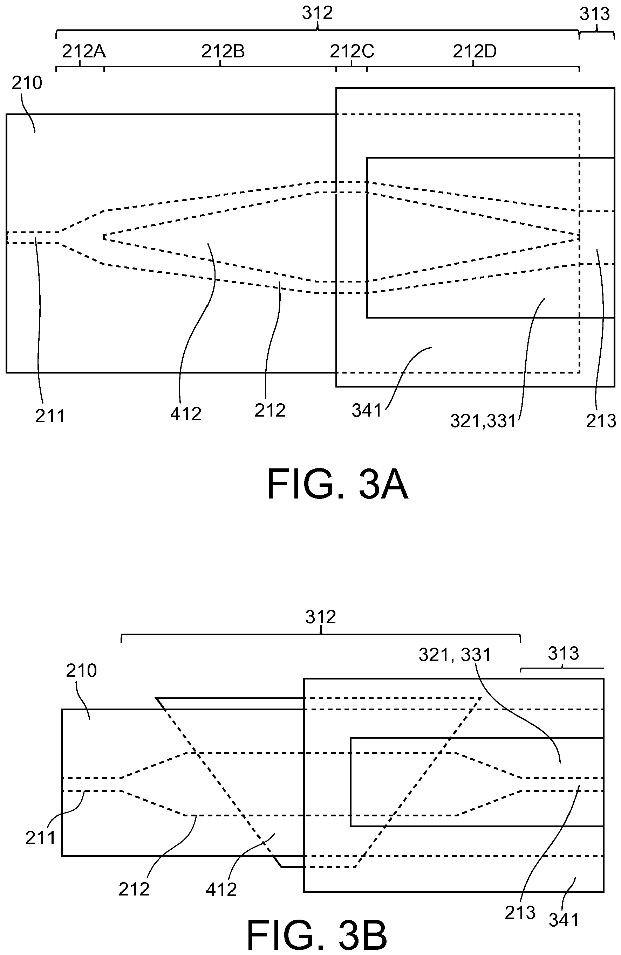

- les figures 3A et 3B illustrent respectivement la forme détaillée de la surépaisseur et de la section de guide d'onde du dispositif optique illustré sur les figures 1A à 1H et un exemple d'une autre forme envisageable d'une surépaisseur et d'une section de guide permettant de former une zone transition optique en variante à la forme du premier mode de réalisation,

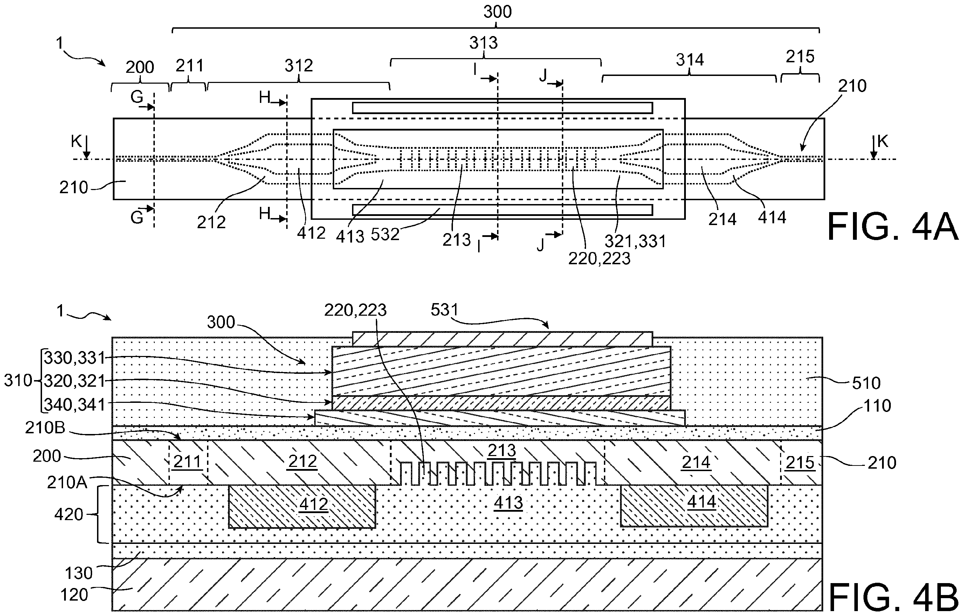

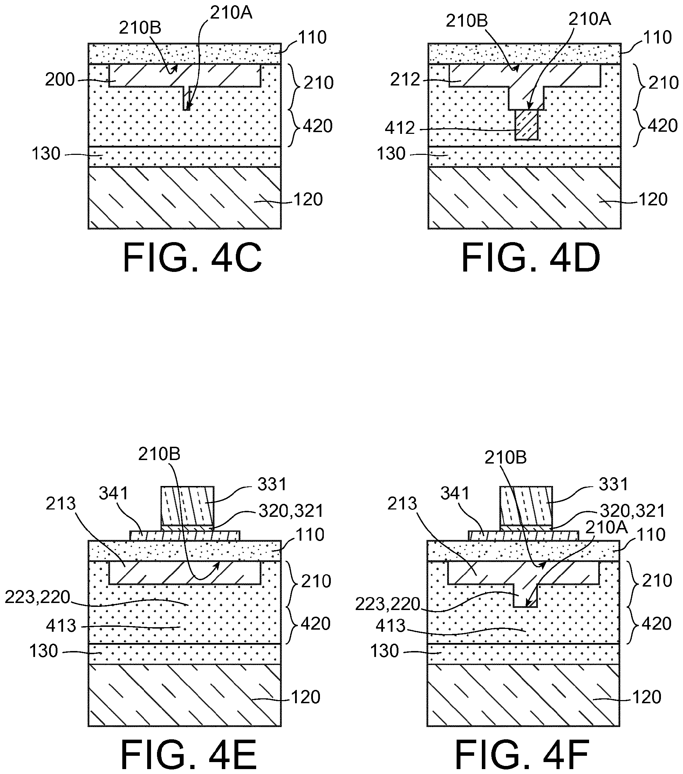

- la figure 4A à 4F illustrent respectivement une vue de dessus, une vue en coupe selon l'axe KK toutes deux schématiques d'un dispositif photonique selon un deuxième mode de réalisation de l'invention dans lequel il est prévu un réseau de Bragg distribué sous la structure à gain, le réseau de Bragg étant du type à « corrugations verticales » partiellement gravées dans la première couche de silicium en tant que structure de contre réaction et quatre vues schématiques en coupe selon les axes GG, HH, Il et JJ de ce même dispositif photonique,

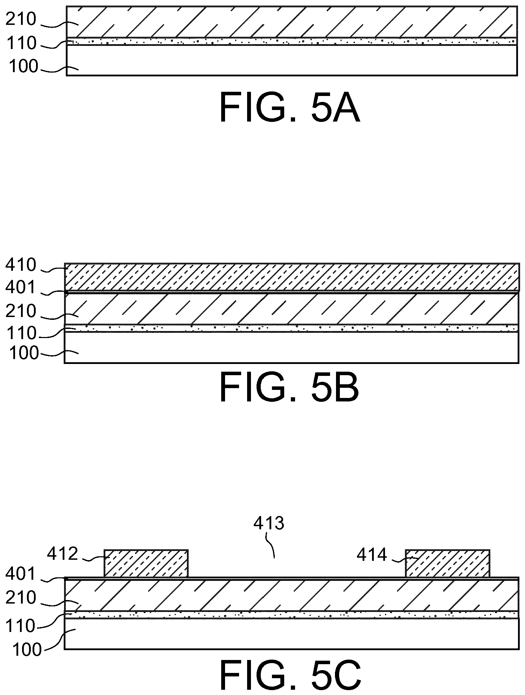

- les figures 5A à 5H illustrent les principales étapes de fabrication d'un dispositif photonique selon un troisième mode de réalisation de l'invention dans lequel il est prévu un réseau de Bragg du type à « corrugations verticales » partiellement gravées dans la première couche de silicium en tant que structure de contre réaction et dont les corrugations sont en regard de la structure à gain,

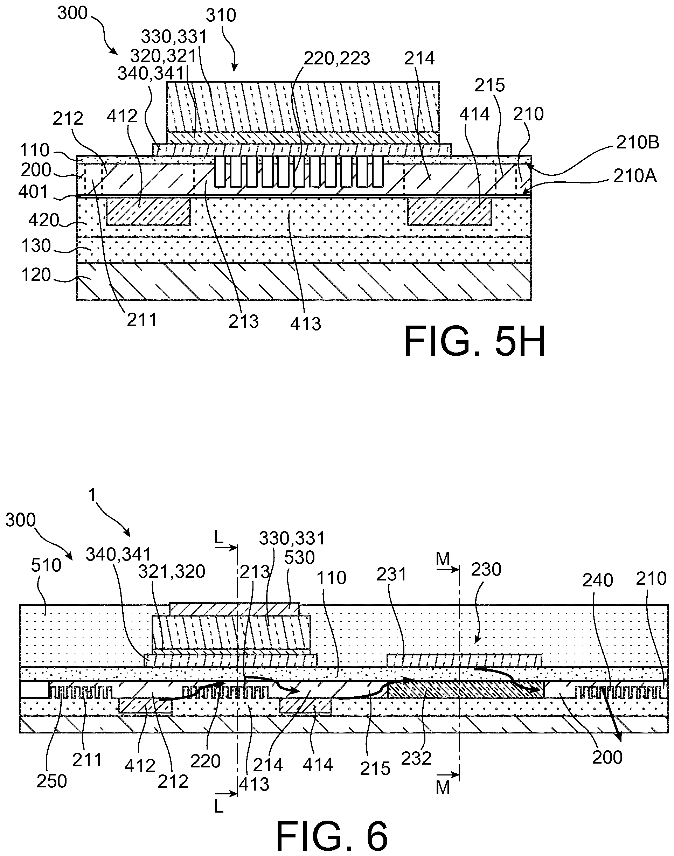

- la figure 6 illustre une vue schématique en coupe d'un dispositif photonique en fonctionnement selon un quatrième mode de réalisation de l'invention dans lequel il est prévu un réseau de Bragg du type à réseau à « corrugations verticales » partiellement gravées en tant que structure de contre réaction, le dispositif photonique comportant un modulateur hybride capacitif et un réseau de couplage surfacique partiellement gravé dans la première couche de silicium,

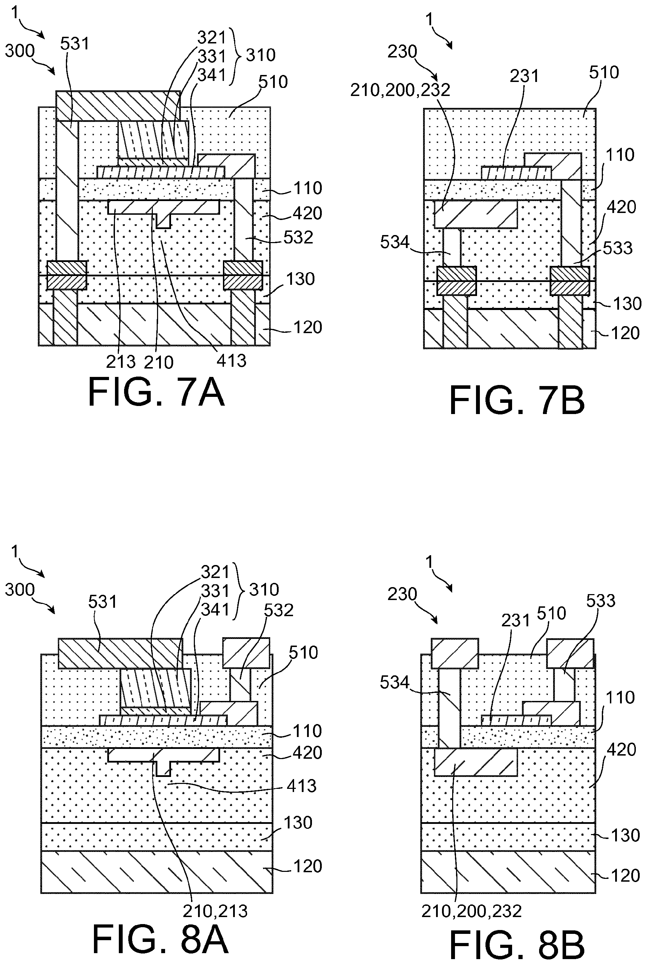

- les figures 7A et 7B illustrent une vue en coupe rapprochée selon les axes LL et MM d'un exemple de prise de contacts électriques pour respectivement la structure à gain et le modulateur capacitif du dispositif photonique illustré sur la figure 6,
- les figures 8A et 8B illustrent une vue en coupe rapprochée selon les axes LL et MM d'un autre exemple de prise de contacts électriques pour respectivement la structure à gain et le modulateur capacitif pour le dispositif photonique illustré sur la figure 6,

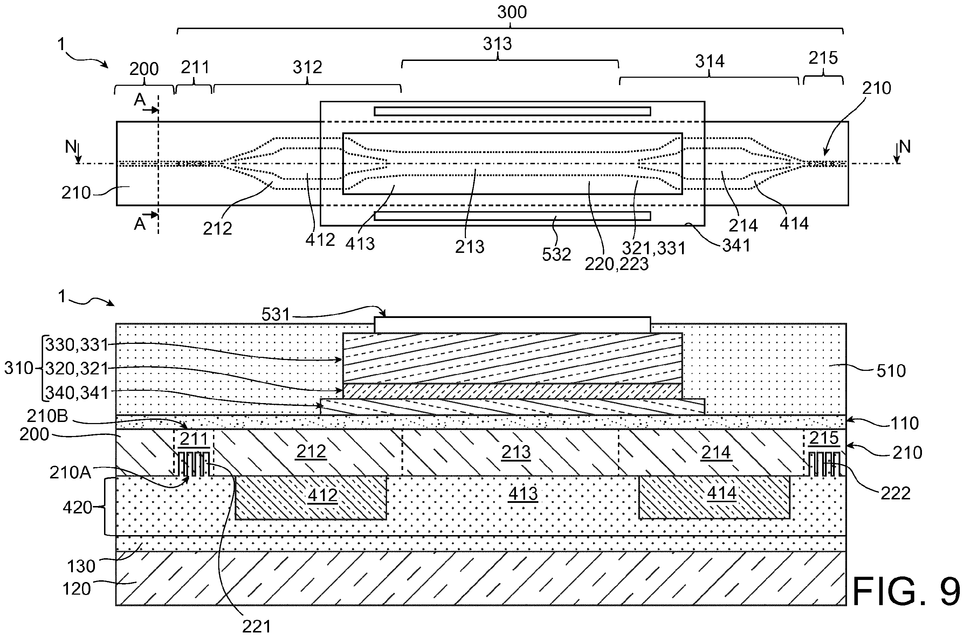

- la figure 9 illustre une vue schématique de dessus et en coupe longitudinale selon l'axe NN d'un dispositif photonique selon un cinquième mode de réalisation dans lequel il est prévu un premier et un deuxième réseau de Bragg dans une première et une cinquième section de guide d'onde ceci pour former une structure de contre réaction optique, le premier et le deuxième réseau de Bragg étant fournis par des corrugations verticales partiellement gravées dans la première couche de silicium,

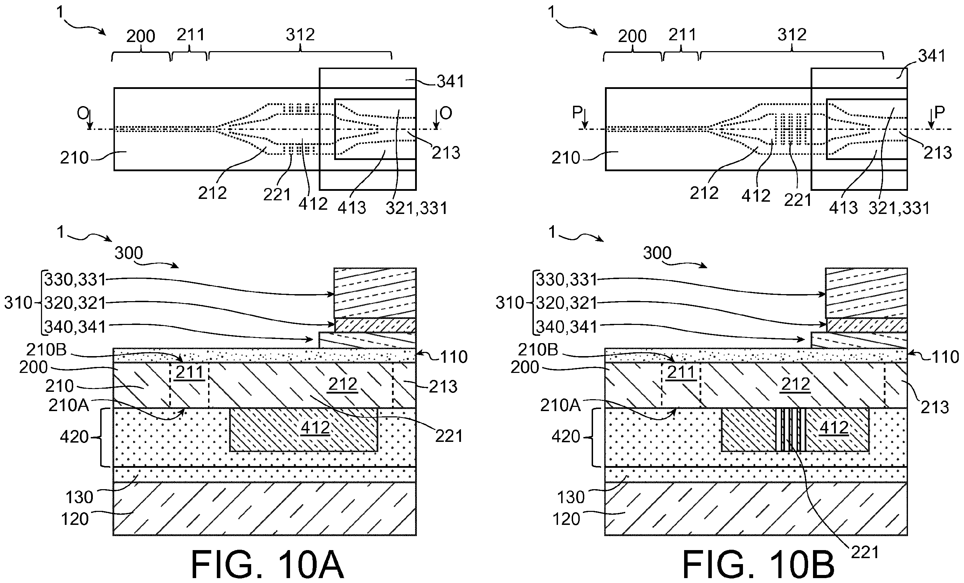

- les figures 10A et 10B illustrent chacune une vue de dessus et une vue en coupe longitudinale selon l'axe respectif OO et PP schématiques et rapprochées d'une zone de transition pour la figure 10A d'un dispositif photonique selon un sixième mode de réalisation dans lequel il est prévu un premier et un deuxième réseau de Bragg accommodés dans respectivement une deuxième et une quatrième section de guide d'onde, et, pour la figure 10B d'un dispositif photonique selon un septième mode de réalisation dans lequel il est prévu un premier et un deuxième réseau de Bragg accommodés dans respectivement une première et une deuxième surépaisseur,

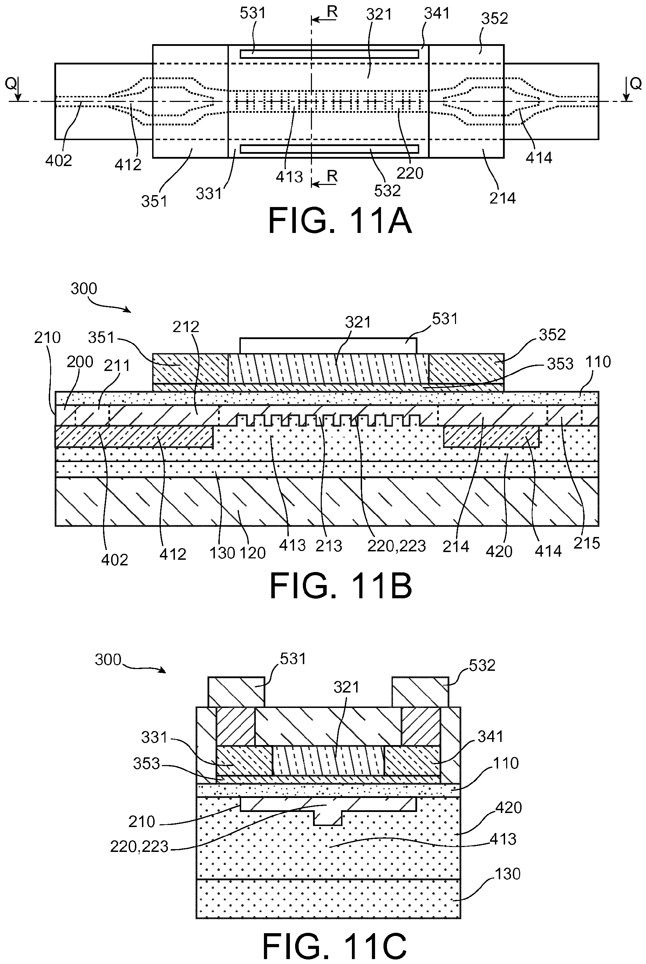

- les figures 11A à 11C illustrent respectivement une vue schématique de dessus, une vue en coupe longitudinale selon l'axe QQ et une vue en coupe latérale selon l'axe RR d'un dispositif photonique selon un huitième mode de réalisation de l'invention dans lequel la structure à gain est une structure à gain du type à « jonction latérale » et dans lequel le guide d'onde silicium est formé à la fois dans la première couche de silicium et une troisième surépaisseur.

Des parties identiques, similaires ou équivalentes des différentes figures portent les mêmes références numériques de façon à faciliter le passage d'une figure à l'autre.

Les différentes parties représentées sur les figures ne le sont pas selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

Les figures 1A et 1B représentent respectivement une vue de dessus et une vue en coupe selon l'axe EE schématiques d'un dispositif photonique 1 selon un premier mode de réalisation de l'invention comportant un guide d'onde silicium 200 et un laser 300 comprenant un milieu à gain 321 apte à émettre de la lumière, le laser 300 étant connecté optiquement au guide d'onde 200.

Le dispositif photonique 1 comporte plus précisément :
- un support 120 comportant une deuxième couche diélectrique 130 recouvrant le support 120,
- une couche intermédiaire 420 en contact avec le support 120 par la deuxième couche diélectrique 130, la couche intermédiaire 420 comportant au moins un matériau diélectrique et une première et une deuxième surépaisseur de silicium 412, 414, la première et une deuxième surépaisseur de silicium 412, 414 étant espacées l'une de l'autre par un espace 413 rempli par ledit matériau diélectrique,
- une première couche de silicium 210 en contact avec la couche intermédiaire à l'opposé du support 120, la première couche de silicium 210 comportant au moins une partie d'un guide d'onde 200, et une première à une cinquième section de guide d'onde 211, 212, 213, 214, 215 distinctes du guide d'onde 200, la première à la cinquième section 211, 212, 213, 214, 215 de guide d'onde se succédant et étant connectée au guide d'onde 200 par au moins l'une de la première et de la cinquième section de guide d'onde 211, 215, la deuxième, quatrième et troisième section de guide d'onde 212, 214, 213 étant en regard de respectivement la première et la deuxième surépaisseur 412, 414 et de l'espace 413,

- une première couche en matériau diélectrique 110 recouvrant la couche de silicium 210 sur une face de la première couche de silicium 210 opposée à la couche intermédiaire 420,
- une structure à gain 310 comportant au moins un milieu à gain 321 apte à émettre de la lumière, la structure à gain 310 présentant une portion centrale en regard de l'espace 413 et une première et une deuxième extrémité en regard de la première et la deuxième surépaisseur 412, 414, ainsi, la portion centrale de la structure à gain 310 forme avec l'espace 413 et la troisième section de guide d'onde 213 un guide d'onde hybride laser 313, les deuxième et quatrième section de guide d'onde 212, 214 et les première et deuxième surépaisseurs 412, 414 de silicium formant une première et une deuxième zone de transition optique 312, 314 d'un mode optique entre le guide d'onde hybride laser 313 et respectivement la première et la cinquième section de guide d'onde 211, 215,
- une structure de contre réaction 220 pour former une cavité oscillante comprenant le milieu à gain 321 de manière à former le laser 300 connecté optiquement au guide d'onde 200 par la première section de guide d'onde 211, la structure de contre réaction 220 étant fournie dans ce premier mode de réalisation de l'invention par un réseau de Bragg distribué 223 accommodé dans la troisième section de guide d'onde 213,
- un premier et un deuxième contact électrique 531, 532 pour contacter électriquement la structure à gain 310,
- une couche d'encapsulation 510 encapsulant la structure à gain et le premier et deuxième contact électrique 531, 532.

On notera que, par simplification et comme cela est indiqué par la suite, que les figures 1A et 1B n'illustrent pas de défaut quart d'onde dans le réseau de Bragg distribué 223, ou de réflecteur total d'un côté du laser; l'un ou l'autre étant connus de l'homme de l'art pour assurer l'émission du laser du type DBF suivant un unique mode de la cavité. On notera également que pour en faciliter la lecture, la figure 1A a été schématisée pour ne faire figurer que certaines composantes du dispositif photonique. Ainsi, par exemple, le contact électrique 531, la couche d'encapsulation 510, le matériau diélectrique de la couche d'encapsulation 420 et le support 120 n'ont pas été représentés sur la figure 1A. Dans ce même but, une telle schématisation est également utilisée pour l'ensemble des vues de dessus du présent document et notamment pour les figures 1G, 2B, 2C, 2G, 3A, 3B, 4A, 9, 10A, 10B et 11A.

Le support 120 est un support compatible avec les contraintes de la microélectronique et de l'optoélectronique et peut être un support en matériau semi-conducteur ou en matériau diélectrique. Dans une application particulière de l'invention, le support peut être un support en silicium cristallin. Selon cette possibilité et selon une variante non illustrée les figures 1A et 1B, le support peut également intégrer des composants électroniques de commande et/ ou de lecture complémentaire aux composants optiques, tels que le laser 300 et les composants intégrés au guide d'onde 200, et des interconnexions électriques reliant lesdits composants électriques audits composants optiques. De la même façon et selon une variante à ce premier mode de réalisation, comme cela est décrit par la suite en lien avec les figures 7A et 7B, le substrat peut également comporter des via conducteurs électriques traversants participant à la formation des contacts électriques 5631, 532, 533, 534 permettant une connexion électrique de ces mêmes composants optiques à un deuxième substrat, le deuxième substrat dit de commande, intégrant lesdits composants électroniques de commande et/ ou de lecture complémentaire aux composants optiques.

Comme illustré sur la figure 1B, le support 120 comporte une deuxième couche diélectrique 130.

La deuxième couche diélectrique 130 est préférentiellement adaptée pour permettre un assemblage par collage direct de la couche intermédiaire 420 sur le support 120. Ainsi, la deuxième couche diélectrique 130 présente à cet effet une deuxième surface de collage plane. Dans l'application particulière de l'invention, la deuxième couche diélectrique 130 est réalisée en dioxyde de silicium SiO₂.

La couche intermédiaire 420 comporte une première face, formant préférentiellement une première surface de collage plane, par laquelle elle est en contact avec la deuxième couche diélectrique 130, et une deuxième face opposée à la première face. La couche intermédiaire 420 comporte en outre :
- la première et la deuxième surépaisseur 412, 414 de silicium espacées l'une de l'autre par un espace 413,
- un ou plusieurs matériaux diélectriques enfermant la première et la deuxième surépaisseur 412, 414 et remplissant l'espace 413, ledit matériau diélectrique formant préférentiellement la première surface de la couche intermédiaire 420.

Le matériau diélectrique de la couche diélectrique est préférentiellement du dioxyde de silicium SiO₂. Selon une possibilité de l'invention, non illustrée sur les figures 1A à 1B, la couche intermédiaire peut comporter plusieurs matériaux diélectriques sous la forme de plusieurs sous-couches.

La première et la deuxième surépaisseur 412, 414 sont réalisées en un silicium sélectionné parmi un silicium mono-cristallin, un silicium amorphe ou un silicium poly-cristallin. L'épaisseur de la première et la deuxième surépaisseur 412,414 est choisie pour permettre, avec respectivement les deuxième et quatrième sections de guide d'onde 212, 214, et les première et deuxième extrémités de la structure à gain 310, une transition adiabatique entre le guide d'onde hybride laser 313 et respectivement la première et la cinquième section de guide d'onde 211, 215. Ainsi dans une application particulière de l'invention dans laquelle la première couche de silicium 210 présente une épaisseur de 300 nm, la première et la deuxième surépaisseur 412, 414 présentent une épaisseur de 200 nm.

Bien entendu, si dans une configuration usuelle de l'invention, chacune de la première et la deuxième surépaisseur 412, 414 présente une épaisseur constante, il est également envisageable que chacune de la première et la deuxième surépaisseur 412, 414 ait une épaisseur variable, l'épaisseur maximale étant alors adaptée pour permettre, avec respectivement les deuxième et quatrième sections de guide d'onde 212, 214 et les première et deuxième extrémités de la structure à gain 310, une transition adiabatique entre le guide d'onde hybride laser 313 et respectivement la première et la cinquième section de guide d'onde 211, 215.

La première et la deuxième surépaisseur 412, 414 et l'espace 413 les séparant sont agencées dans la couche intermédiaire 420 en regard de respectivement la deuxième, la quatrième et de la troisième section de guide d'onde 212, 214, 213 aménagées dans la première couche de silicium 210.

La forme de la première et la deuxième surépaisseur est également choisie pour permettre, avec respectivement les deuxième et quatrième sections de guide d'onde 212, 214, et respectivement les première et deuxième extrémités de la structure à gain 310, une transition adiabatique entre le guide d'onde hybride laser 313 et respectivement la première et la cinquième section de guide d'onde 211, 215. Ainsi, comme illustré schématiquement sur la figure 1A, la première et la deuxième surépaisseur 412, 414 présentent selon une direction de guidage du guide d'onde 200 une forme fuselée. Chacune de la première et de la deuxième surépaisseur 412, 414 présentent, selon une direction allant de l'intérieur de la structure à gain 310 vers l'extérieur de la structure à gain 310:
- sur une première partie de sa longueur une section transversale croissante,
- sur une deuxième partie de sa longueur, une section transversale constante,
- sur une troisième partie de sa longueur, une section transversale décroissante.

Bien entendu, une telle forme de la première et de la deuxième surépaisseur 412, 414 est donnée à titre d'exemple. D'autres formes, comme cela est exemplifié dans la suite de ce document, sont parfaitement envisageables sans que l'on sorte du cadre de l'invention tant que lesdites formes, combinées aux formes de la deuxième et de la quatrième section de guide d'onde212, 214 et aux formes des première et deuxième extrémités de la structure active 310, autorisent la formation d'une première et d'une deuxième zone de transition optique 312, 314 entre le guide d'onde hybride laser 313 et respectivement la première et la cinquième section de guide d'onde 211, 215.

La couche intermédiaire 420 est en contact par sa deuxième face avec la première couche de silicium 210. La première couche de silicium 210 comporte une première face 210A par laquelle elle est en contact avec la couche intermédiaire 420 et une deuxième face 210B opposée à sa première face 210A.

La première couche de silicium 210 est une couche de silicium cristallin issue d'un substrat du type couche de silicium 210 sur une couche diélectrique 110. Ce type de substrat est plus connu sous la dénomination anglaise de « silicon on insulator » et le sigle anglais associé SOI qui veulent dire 'silicium sur isolant'. Dans l'application particulière de l'invention, la couche de silicium 210 est une couche de silicium issue d'un substrat silicium comportant une couche de silicium sur dioxyde de silicium SiO₂, autrement dit un substrat SOI. Une telle couche de silicium issue d'un substrat du type substrat SOI offre entre autre avantage de posséder une bonne qualité cristalline et une épaisseur contrôlée, permettant de fournir un guide d'onde 200 présentant peu de perte optique. La couche de dioxyde de silicium, qui correspond à la première couche diélectrique 110, est connue sous la dénomination anglaise « Buried oxide » et le sigle BOX pour oxyde enterré. Une telle couche de silicium issue d'un substrat du type substrat SOI présente l'avantage de présenter une bonne qualité cristalline et une épaisseur contrôlée, permettant de fournir un guide d'onde 200 présentant peu de perte optique, et d'également permettre la fourniture d'une première couche diélectrique d'épaisseur et de planéité contrôlées par l'intermédiaire de la couche BOX.

La première couche de silicium 210 présente une épaisseur adaptée pour former le guide d'onde 200 et les composants optiques que le guide d'onde 200 accommode. Ainsi, dans l'application particulière de l'invention, la première couche de silicium 210 présente une épaisseur de 300 nm. De cette manière, les composants optiques que le guide d'onde 200 accommode présentent une configuration de fonctionnement optimale.

La première couche de silicium 210 structurée présente une structuration telle que la première couche de silicium 210 comprend le guide d'onde 200 et les première à cinquième sections de guide d'onde 211, 212, 213, 214, 215.

Bien entendu, comme cela est illustré à la suite de ce document, notamment en lien avec les figures 6 à 9, le guide d'onde 200 peut également accommoder d'autres composants optiques, tels qu'un modulateur optique et un réseau de couplage surfacique, non illustrés sur les figures 1A à 1H.

Dans l'application pratique de l'invention, comme illustré sur la figure 1C représentant une vue en coupe du guide d'onde 200 selon un axe AA, le guide d'onde 200 comporte, sur une première partie de l'épaisseur de la première couche de silicium 210 comportant la deuxième face 210B de la première couche de silicium 210, une embase et, sur une deuxième partie de l'épaisseur, comportant la première face 210A de la couche de silicium 210, une portion, dite arête, présentant une section latérale réduite vis-à-vis de l'embase.

Bien entendu, une telle forme du guide d'onde 200 est purement illustrative de l'application pratique de l'invention et d'autre forme sont envisageables sans qu'on sorte du cadre de l'invention. Ainsi et par exemple, le guide d'onde 200 peut également présenter une section latérale constante ou encore présenter une embase comportant la première face 210A sans que l'on sorte du cadre de l'invention.

Le guide d'onde 200 est connecté optiquement à la première section de guide d'onde 211. Dans ce premier mode de réalisation de l'invention, la première et la cinquième section de guide d'onde 211, 215 présente une configuration similaire à celle du guide d'onde 200. Ainsi, selon l'application pratique de l'invention, la première et la cinquième section présente une vue en coupe identique à celle du guide d'onde 200 et telle qu'illustrée sur la coupe selon l'axe AA montrée sur la figure 1C.

Les première à cinquième sections de guide d'onde 211, 212, 213, 214, 215 se succédant, la première section de guide d'onde 211 est donc connectée optiquement à la deuxième section de guide d'onde 212 étant elle-même connectée optiquement à la troisième section de guide d'onde 213, et ainsi de suite. De cette manière, les première à la cinquième sections de guide d'onde 211, 212, 213, 214, 215 sont connectées optiquement au guide d'onde 200 par la première section de guide d'onde 211.

Ainsi, comme illustré schématiquement sur la figure 1A, La deuxième et la quatrième portion 212, 214 présentent, de manière similaire à la première et deuxième surépaisseur 412, 414, chacune, selon une direction allant de l'intérieur de la structure à gain 310 vers l'extérieur de la structure à gain 310 :
- sur une première partie de sa longueur une section transversale croissante,
- sur une deuxième partie de sa longueur, une section transversale constante,
- sur une dernière partie de sa longueur, une section transversale décroissante.

Selon une possibilité de l'application particulière de l'invention, figurée sur la vue en coupe selon l'axe BB montrée sur la figure 1D, chacune de la deuxième et la quatrième section de guide d'onde 212, 214, de la même façon que le guide d'onde 200 et que les première et cinquième section de guide d'onde 211, 215, peut comporter une première et une deuxième partie de l'épaisseur du guide d'onde 200 présentant des largeurs transversales différentes. Ainsi, la deuxième partie comprenant la première face 210A de la première couche de silicium 210 présente une largeur transversale plus faible que la première partie qui comporte la deuxième face 210B de la première couche de silicium 210. Selon cette possibilité, la première partie forme une embase qui peut présenter une section latérale constante, seule la deuxième partie, dite arête, présente donc une forme fuselée telle qu'illustrée sur la figure 1A. Autrement dit, l'arête de la deuxième et de la quatrième section de guide d'onde 212, 214 présente ses deux extrémités en forme de trapèze, les bases dudit trapèze étant transversale à la direction de propagation de la lumière, la plus petite base étant la base la plus externe de ladite section de guide d'onde 212, 214. Comme illustré sur la figure 1D, la largeur transversale de l'arête de la deuxième et de la quatrième section de guide d'onde 212, 214 présente une largeur transversale supérieure à celle de la surépaisseur 412, 414 qui la recouvre en partie.

Bien entendu, comme cela est décrit à la suite de ce document d'autres configurations de la première et la deuxième portion 211, 212 du guide d'onde 200 sont également envisageables sans que l'on sorte du cadre de l'invention.

La première couche de silicium 210 comporte, accommodé dans la troisième section de guide d'onde 213, la structure de contre réaction optique 220. Dans ce premier mode de réalisation la structure de contre réaction 220 est une structure en réseau de Bragg distribué 223 sous la partie centrale de la structure à gain 310. Plus précisément, comme illustré sur la vue dessus de la figure 1A, la structure de cotre réaction optique 220 est un réseau de Bragg distribué 223 à « corrugations latérales », c'est-à-dire que la variation d'indice optique du réseau de Bragg est fournie par une variation de la largeur transversale du guide d'onde.

Avec une telle structure de contre réaction 220, le laser est un laser du type laser à rétroaction répartie également connu sous la dénomination anglaise « Distributed FeedBack laser » et le sigle correspondant laser DFB.

Dans l'application pratique de l'invention et comme illustré sur les vues en coupe selon les axes CC et DD montrées sur les figures 1D et 1E, la variation de largeur transversale pour le réseau de Bragg distribué 223 est réalisée sur une première partie de l'épaisseur de la première couche de silicium 210 qui s'étend à partir de la première face 210A de la première couche de silicium 210. Ainsi, la structure de contre réaction 220 comprend, de la même façon que les première, deuxième, quatrième et cinquième sections de guide d'onde, une embase sur une première partie de l'épaisseur de la première couche de silicium 210 s'étendant à partir de la deuxième face 210B de cette dernière, et une arête sur une deuxième partie de l'épaisseur de la couche de silicium 210 s'étendant à partir de la première face 210A. L'embase présente une largeur transversale constante, cette première partie de l'épaisseur présentant typiquement une épaisseur de 150 nm. L'arête présente par alternance une largeur transversale relativement importante, qui et dire « large », et une largeur transversale relativement faible, qui est dite « étroite », pour former le réseau de Bragg distribué 223, la deuxième partie de l'épaisseur présentant typiquement une épaisseur de 150 nm. Dans l'arête, le pas d'alternance entre la largeur transversale importante et la largeur transversale faible, selon le principe d'un réseau de Bragg, est sensiblement de λ/2n_{eff}, λ étant la longueur d'onde d'émission du laser 300 et n_{eff} l'indice effectif moyen du mode guidé par le guide d'onde hybride 313. Avec une telle configuration du réseau de Bragg distribué, le réseau de Bragg distribué 223 est un réseau de Bragg à « corrugations latérales » partiellement gravées dans l'épaisseur de la première couche de silicium 210.

Bien entendu, comme cela est montré dans les modes de réalisation suivants de l'invention, la structure de contre réaction 220 peut être fournie par un autre type de réflecteur sans que l'on sorte du cadre de l'invention. En particulier, le réflecteur distribué 223 peut être fourni par un réseau de Bragg distribué à « corrugations latérales » totalement gravées dans l'épaisseur de la première couche de silicium 210.

Selon une possibilité avantageuse de l'invention non illustrée sur les figures 1A à 1F et qui s'applique dans le cas où la structure de contre réaction optique 220 est fournie par un réflecteur distribué, le réseau de Bragg distribué peut comporter un défaut de phase de type quart d'onde afin d'optimiser une sélectivité de la cavité oscillante.

En variante de cette possibilité et afin d'optimiser la sélectivité de la cavité oscillante, la première ou la cinquième section de guide d'onde 211, 215 peut accommoder un réflecteur sensiblement total, le réflecteur total pouvant être sélectionné parmi les réflecteurs de type Sagnac, les réseaux de Bragg distribués, les miroirs du type facette avec traitement haute réflectivité. Dans le même but et en variante, il est également envisageable que l'un parmi la deuxième section de guide d'onde 212, la quatrième section de guide d'onde 214, la première surépaisseur 412, la deuxième surépaisseur414, l'ensemble deuxième section de guide d'onde 212 et première surépaisseur 412, et l'ensemble quatrième section de guide d'onde 214 et deuxième surépaisseur 414 accommode un réflecteur sensiblement total, le réflecteur total pouvant être sélectionné parmi les réflecteurs de type réseaux de Bragg distribués, les miroirs du type facette avec traitement haute réflectivité

La première couche de silicium 210, pour les parties de la première couche de silicium 210 évidées lors d'une opération précédente, comporte un matériau diélectrique, par exemple celui de la couche intermédiaire 420.

La première couche de silicium 210 présente sa deuxième face 210B en contact avec la première couche diélectrique 110. La première couche diélectrique 110 comporte une première face par laquelle elle est en contact avec la première couche de silicium 210, et une deuxième face opposée à la première face.

La première couche diélectrique 110 est une couche diélectrique issue d'un substrat du type silicium sur isolant ou SOI, celle-ci étant fournie par l'isolant sur lequel est disposé la première couche de silicium 210. Selon l'application pratique de l'invention et comme cela a déjà été indiqué en lien avec la première couche de silicium 210, la première couche diélectrique 110 est une couche de dioxyde de silicium dont l'épaisseur est, par exemple, de 30 ou de 50 nm.

Selon une possibilité optionnelle de l'application pratique de l'invention, la première couche diélectrique peut être une couche d'isolant d'un substrat du type silicium sur isolant dont l'épaisseur a été amincie.

La première couche diélectrique 110 est en contact avec la structure à gain 310 par sa deuxième face.

Comme illustré sur la figure 1, la structure à gain 310 comporte :
- une première zone semi-conductrice 341 d'un premier type de conductivité formée dans une première couche semi-conductrice 340,
- le milieu à gain 321 formé dans une deuxième couche semi-conductrice 320,
- une troisième zone semi-conductrice 331 d'un deuxième type de conductivité opposé au premier type de conductivité et formée dans une troisième couche semi-conductrice 330.

Selon une configuration usuelle de l'invention, la première, la deuxième et la troisième couche semi-conductrice 340, 320, 330, et donc les première et troisième zones semi-conductrices 341, 331 et le milieu à gain 321, sont tous trois réalisés en matériaux semi-conducteurs à gap direct tels que des semi-conducteurs III-V. Ainsi, La première, et la troisième couche semi-conductrice 340, 330 sont préférentiellement réalisées dans des semi-conducteurs III-V, tel que du phosphure d'indium InP ou du l'arséniure de gallium GaAs, tandis que la deuxième couche semi-conductrice 320 est préférentiellement formée par un empilement de composés binaires, ternaires quaternaires de matériaux semiconducteur III-V.

Le premier et le deuxième type de conductivité sont choisis parmi le type de conductivité dans lequel les porteurs majoritaires sont des électrons, c'est-à-dire celui fourni par un dopage dit N, et le type de conductivité dans lequel les porteurs majoritaires sont des trous, c'est-à-dire celui fourni par un dopage dit P.

Les figures 1G et 1H illustrent ainsi, par une vue de dessus et une vue en coupe latérale selon l'axe FF, plus précisément l'agencement des première, et troisième zones semi-conductrices 341, 331 et du milieu à gain 321 afin de former la structure à gain 310. La premiere zone semi-conductrice 341 présente une première face en contact avec la première couche diélectrique 110 et une deuxième face opposée à la première face par laquelle elle est en contact avec le milieu à gain 321. Le milieu à gain 321 comporte une première face par laquelle il est en contact avec la première zone semi-conductrice 341 et une seconde face opposée à la première face par laquelle il est en contact avec la troisième zone semi-conductrice 331.

La première zone semi-conductrice 341 présente une largeur supérieure à celle du milieu à gain 321 et de la troisième zone semi-conductrice 331 afin d'autoriser une prise de contact au moyen du deuxième contact électrique 532 qui est, comme montré sur les figure 1G et 1H, dédoublé. Ainsi la première zone semiconductrice 341 présente en contact sur sa deuxième face, de part et d'autre du milieu à gain 321 et de la troisième zone semi-conductrice 331, un premier et un deuxième contact métallique s'étendant longitudinalement, ce premier et deuxième contact se prolongent chacun par une interconnexion traversant la couche d'encapsulation 510 et un plot de contact affleurant de la couche d'encapsulation 510. Ce premier et deuxième contact métallique, ces interconnexions et les plots de contact forment le deuxième contact électrique 532.

Le milieu à gain 321 et la troisième semi-conductrice 331 présente une largeur identique. La première zone semi-conductrice présente sa deuxième face en contact avec le premier contact électrique 531 sous la forme, par exemple, d'un plot de contact longitudinale affleurant de la couche d'encapsulation 510. Le plot de contact longitudinal forme ainsi le premier contact électrique 531.

La structure à gain 310 est agencée, comme illustré sur la figure 1B, en contact avec la première face de la première couche diélectrique 1 10 de telle manière que la structure à gain 310 présente une portion centrale en regard de l'espace 413. Avec une telle configuration :
- la portion centrale de la structure à gain 310 forme avec l'espace 413 et la troisième section de guide d'onde 213 un guide d'onde hybride laser,
- la deuxième section de guide d'onde 212, la première surépaisseur 412 et la première extrémité de la structure à gain 310 forment une première zone de transition optique 312 du mode optique entre le guide d'onde hybride optique 313 et la première section de guide d'onde 211,
- la quatrième section de guide d'onde 214, la deuxième surépaisseur 414 et la deuxième extrémité de la structure à gain 312 forment une deuxième zone de transition optique 314 du mode optique entre le guide d'onde hybride optique 313 et la cinquième section de guide d'onde 215.

Ainsi, la structure à gain 310 est, à l'exception de ces première et deuxième extrémités, en regard de la troisième section de guide d'onde 213 et de l'espace 413. Avec un tel agencement, le milieu à gain est couplé optiquement avec la structure de contre réaction optique 220 permettant de former une cavité oscillante comprenant le milieu à gain 321.

Comme illustré sur les figures 1B et 1H, la structure à gain 310 est en enterrée dans la couche d'encapsulation 510 avec les plots de contact du premier et du deuxième contact électrique 531, 532 qui affleurent.

Ainsi la structure à gain 310, les première à cinquième sections 211, 212, 213, 214, 215, avec la structure de contre réaction optique 220 quelles accommodent, l'espace 413, et les première et deuxième surépaisseurs 411, 412 forment ensemble le laser 300.

Les figures 2A à 2G illustrent les principales étapes de fabrication d'un procédé de fabrication d'un dispositif photonique 1 selon l'invention. Un tel procédé de fabrication, de la même façon que l'ensemble des procédés décrits dans le présent document, est particulièrement adapté pour la mise en œuvre de ses étapes en parallèle pour permettre la formation d'une pluralité de dispositifs. Avec une telle mise en œuvre en parallèle, un tel procédé de fabrication de dispositifs photoniques est dit collectif.

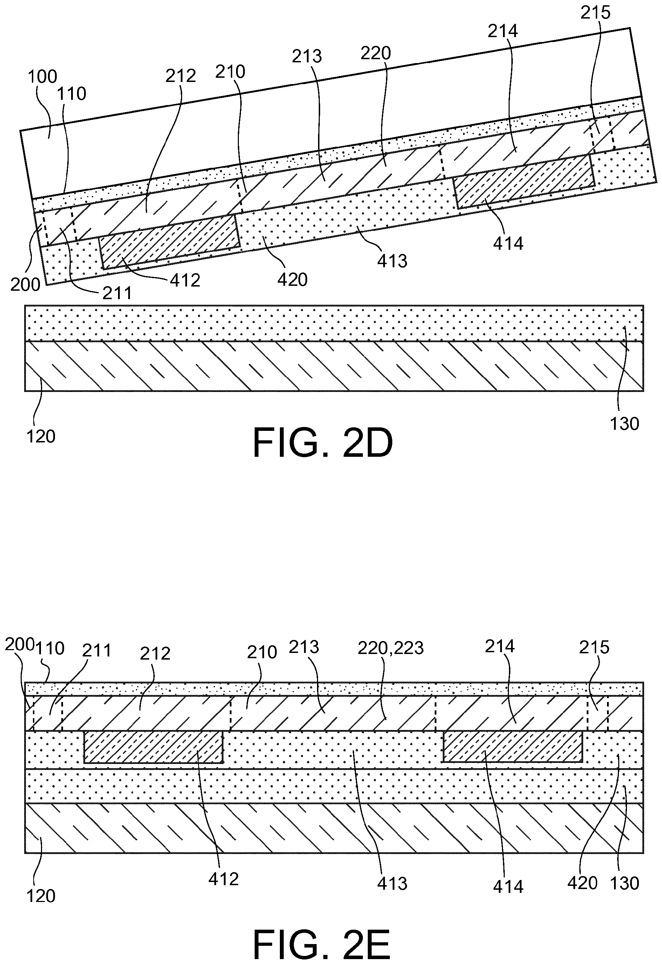

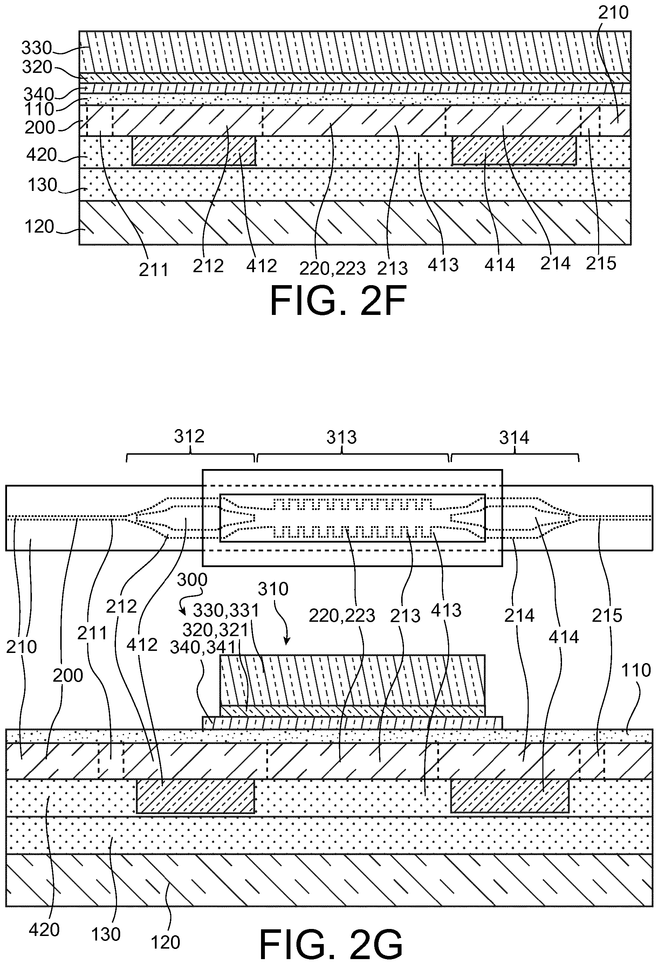

Un tel procédé comporte les étapes suivantes :
- fourniture du substrat 100 associé avec la première couche de silicium 210 sur une première couche diélectrique 110, comme illustré sur la figure 2A,
- structuration de la première couche de silicium 210 pour former le guide d'onde 200 et les première à cinquième sections de guide d'onde 211, 212, 213, 24, 215 distinctes du guide d'onde 200, la première à la cinquième section de guide d'onde 211, 212, 213, 214, 215 se succédant et étant connectées optiquement au guide d'onde 200 par au moins l'une de la première et la cinquième section de guide d'onde 211, 215, la troisième section de guide d'onde accommodant le réseau de Bragg distribué 223 formant la structure de contre réaction optique 220 et obtenu par structuration de corrugations latérales de la section guide d'onde 213, tel qu'illustré sur la figure 2B,
- formation de la première et d'une deuxième surépaisseur 412, 414 de silicium séparée l'une de l'autre par un espace 413, la première et la deuxième surépaisseur 412, 414 et l'espace étant en regard de respectivement les deuxième, quatrième et troisième sections de guide d'onde 212, 214, 213,
- enterrement d'au moins la première et de la deuxième surépaisseur 412, 414 de silicium par au moins un matériau diélectrique et planarisation dudit matériau diélectrique afin de former la couche intermédiaire 420, un ensemble substrat 100/ première couche diélectrique 110/ première couche de silicium 210/ couche intermédiaire 420 étant ainsi formé, comme illustré sur la figure 2C,
- fourniture d'un support 120 comportant une deuxième couche diélectrique 130,
- assemblage de l'ensemble substrat 100/ première couche diélectrique 110/ première couche de silicium 210/ couche intermédiaire 420 sur le support 120 en contact avec la deuxième couche diélectrique 130, l'assemblage étant réalisé par collage de la couche intermédiaire sur la couche diélectrique 130, comme illustré sur la figure 2D,
- suppression du substrat 120, comme illustré sur la figure 2E,
- formation des première, deuxième et troisième couches semi-conductrices 340, 320, 340, comme illustré sur la figure 2F,
- gravure partielle des première, deuxième et troisième couches semi-conductrices 340, 320, 340 de manière à former la structure à gain 310 étant en contact avec la première couche diélectrique 110, et comportant la deuxième couche semi-conductrice 320 en tant que milieu à gain 321 et étant formée en présentant une portion centrale en regard de l'espace 413 et une première et une deuxième extrémité en regard d'une partie de la première et la deuxième surépaisseur 411, 412, ainsi, la portion centrale de la structure à gain 310 forme avec l'espace 413 et la troisième section de guide d'onde 213 un guide d'onde hybride laser, les deuxième et quatrième section de guide d'onde 212, 214, les première et deuxième surépaisseurs 412, 414 de silicium et les première et deuxième extrémités de la structure active 310 formant une première et une deuxième zone de transition optique 312, 314 optique du mode optique entre le guide d'onde hybride laser 313 et respectivement la première et la cinquième section de guide d'onde 211, 215, le dispositif photonique 1 étant ainsi formé, comme illustré sur la figure 2G.

Dans un tel procédé de fabrication, l'étape de formation de la première et de la deuxième surépaisseur 412, 414 peut être mise en œuvre de différentes manières.

Ainsi, selon une première possibilité, la première et la deuxième surépaisseur 412, 414 peuvent être formées par dépôt sélectif de silicium. Une étape de formation de la première et de la deuxième surépaisseur 412, 414 selon cette possibilité comporte la sous étape suivante :
- dépôt sélectif de silicium pour former la première et de la deuxième surépaisseur 412, 414.

Afin de fournir une première et une deuxième surépaisseur 412, 414 formée en silicium cristallin, cette sous-étape de dépôt de silicium peut être une étape de dépôt épitaxial, tel qu'un dépôt chimique en phase vapeur ou un dépôt en épitaxie par jet moléculaire.

On notera que le dépôt sélectif de silicium pour former la première et la deuxième surépaisseur 412, 414 nécessite généralement une sous-étape préalable de formation d'un masque protégeant les parties de la première couche de silicium 210 à ne pas recouvrir, ce masque étant préférentiellement réalisé dans le matériau diélectrique de la couche intermédiaire 420 et une étape de dépôt de silicium sur les parties de la première couche de silicium 210 non protégées.

Ainsi, selon cette possibilité et dans le cas où le masque est réalisé dans le matériau diélectrique de la couche intermédiaire, l'étape de formation de la première et de la deuxième surépaisseur 412, 414 et l'étape d'enterrement sont concomitante est comporte, outre la sous-étape de dépôt sélectif de silicium, les sous-étapes suivantes :
- dépôt d'une première sous-couche de matériau diélectrique,
- planarisation et structuration de la première sous-couche de matériau diélectrique pour former le masque ceci en libérant les zones de la première couche de silicium sur lesquelles sont formées la première et la deuxième surépaisseur 412, 414,
- après la sous étape de dépôt sélectif du silicium, planarisation de la première sous-couche de matériau diélectrique et du silicium déposé, ceci permettant d'assurer une hauteur contrôlée identique pour la première sous-couche et les première et deuxième surépaisseurs 412, 414,
- dépôt d'une deuxième sous-couche de matériau diélectrique pour enterrer la première et la deuxième surépaisseur 412, 414 et ainsi former la couche intermédiaire 420.

Selon une deuxième possibilité, la première et la deuxième surépaisseur 412, 414 peuvent être formées par le dépôt d'une deuxième couche de silicium 410 (illustré en lien avec les figures 5A à 5H en lien avec le troisième mode de réalisation de l'invention) et la suppression, par exemple par gravure, des parties de ladite couche qui ne sont pas destinées à former la première et la deuxième surépaisseur 412, 414. L'étape de formation de la première et la deuxième surépaisseur 412, 414 de silicium selon cette deuxième possibilité comporte ainsi les sous-étapes suivantes :
- dépôt de la deuxième couche de silicium 410 sur la première couche de silicium 210,
- gravure localisée de la deuxième couche de silicium 410 pour former la première et la deuxième surépaisseur 412, 414 de silicium.

Bien entendu, ici aussi, le dépôt de la deuxième couche de silicium 410 peut être un dépôt épitaxial.

Selon une troisième possibilité, la première et la deuxième surépaisseur 412, 414 peuvent être formées par le report d'une deuxième couche de silicium 410 et la suppression, généralement par gravure, des parties de ladite couche qui ne sont pas destinées à former la première et la deuxième surépaisseur 412, 414. L'étape de formation de la première et la deuxième surépaisseur 412, 414 de silicium selon cette troisième possibilité comporte ainsi les sous-étapes suivantes :
- report, par exemple par collage moléculaire, de la deuxième couche de silicium 410 sur la première couche de silicium 210,
- gravure localisée de la deuxième couche de silicium 410 pour former la première et la deuxième surépaisseur 412, 414 de silicium.

On notera que selon cette troisième possibilité, le report de la deuxième couche de silicium 410 se fait généralement au moyen d'un deuxième substrat sur lequel est positionnée ladite deuxième couche de silicium 410 et que l'étape de report de la deuxième couche de silicium 410 consiste généralement en un assemblage par collage direct de l'ensemble deuxième substrat/deuxième couche de silicium 410 sur la couche intermédiaire 420 et en une suppression du deuxième substrat. On notera que selon cette troisième possibilité, le deuxième substrat est généralement un substrat SOI, la couche de deuxième couche de silicium 410 reportée étant alors la couche de silicium sur oxyde dudit substrat et la suppression du substrat consiste à supprimer le substrat et sa couche d'oxyde support de la deuxième couche de silicium 410.

Dans le cadre d'un tel procédé de fabrication et selon une possibilité non illustrée, il est également envisageable de prévoir une étape d'amincissement de la première couche diélectrique 110. Une telle étape d'amincissement de la première couche diélectrique 110 peut être soit une étape de gravure chimique, une étape de gravure sèche, ou une étape de polissage mécano chimique, ou une combinaison de ces étapes, ceci afin de conserver un contrôle optimale et une dispersion minimisée de l'épaisseur de la première couche diélectrique 110.

Dans le cadre d'un tel procédé de fabrication et selon une possibilité non illustrée, il est également envisageable de prévoir une étape de retrait totale de la première couche diélectrique 110, par gravure sèche et une étape de formation d'une première couche diélectrique alternative 110, suivie par une étape planarisation de cette première couche diélectrique alternative 110.
Les figures 3A et 3B illustrent respectivement un exemple de dimensionnement d'une zone de transition optique 312 selon l'application pratique de ce premier mode de réalisation et un exemple de forme alternative d'une telle zone de transition optique 312 autorisant une transition adiabatique entre le guide d'onde hybride laser 313 et la première section de guide d'onde optique 211.
La figure 3A illustre ainsi la forme détaillée d'une zone de transition optique 312 selon l'application pratique du premier mode de réalisation de l'invention.

Dans cet exemple, le guide d'onde 200 et la première section de guide d'onde 211 présente une embase dont la section latérale possédant une largeur de 10 µm alors que l'arête présente une section latérale possédant une largeur de 400 nm.

La deuxième section de guide d'onde 212 présente une embase avec le même dimensionnement que celle du guide d'onde 200 et celle de la première section du guide d'onde 211, c'est-à-dire qui possède une section latérale dont la largeur est 10 µm.

La deuxième section de guide d'onde 212 comporte au niveau de son arête et selon une direction allant de la première section de guide d'onde 211 vers la troisième section de guide d'onde 213 :
- une première portion 212A fuselée, et/ou trapézoïdale, dans laquelle la section latérale de l'arête présente une largeur croissante à partir d'une valeur identique à celle de l'arête de la première section de guide d'onde 211, c'est-à-dire 400 nm, pour atteindre une valeur de 1 µm,
- une deuxième portion 212B fuselée, et/ou trapézoïdale, dans laquelle la section latérale de l'arête présente une largeur croissante à partir d'une valeur de 1 µm pour atteindre une valeur de 3 µm,
- une troisième portion 212C constante dans laquelle la largeur de section latérale de l'arête est maintenue constante à une valeur de 3 µm,
- une quatrième portion 212D fuselée, et/ou trapézoïdale dans laquelle la section latérale de l'arête présente une largeur décroissante à partir d'une valeur identique à celle de la troisième portion constante, c'est-à-dire une largeur de 3 µm, pour atteindre la valeur de largeur de la section latérale de la troisième section de guide d'onde, c'est à dire de 0,8 µm.

Selon le même exemple de dimensionnement, la première surépaisseur 412 est en regard de la deuxième section de guide d'onde 212 uniquement au niveau de la deuxième, troisième et quatrième portion 212B, 212C, 212D de la deuxième section de guide d'onde 212. La première surépaisseur comporte ainsi selon une direction allant de la première section de guide d'onde 211 vers la troisième section de guide d'onde 213 :
- une première portion fuselée, et/ou trapézoïdale, en regard de la deuxième portion 212B de la deuxième section de guide d'onde 212, la première portion de la première surépaisseur présentant une section latérale qui croît à partir d'une largeur de 120 nm pour atteindre une largeur de 2,6 µm,
- une deuxième portion constante en regard de la troisième portion constante de la deuxième section de guide d'onde 212, la deuxième portion constante présentant une largeur constante de 2,6 µm,
- une troisième portion fuselée, et/ou trapézoïdale, en regard de la quatrième portion 212D de la deuxième section de guide d'onde 212, la troisième portion de la première surépaisseur présentant une section latérale qui décroît à partir d'une largeur de 2,6 µm pour atteindre une largeur de120 nm.

Selon ce même l'application pratique du premier mode de réalisation de l'invention, la structure à gain présente la forme suivante :
- la premiere extrémité de la première zone semi-conductrice 341 se situe en regard de la troisième portion 212C constante de la deuxième section de guide d'onde 212, la première zone semi-conductrice 341 ayant une section latérale de largeur constante et égale à 70 µm, cette largeur étant identique à la section latérale de la première zone semi-conductrice 341 dans le guide d'onde hybride 313,
- les premières extrémités du milieu à gain 321 et de la troisième zone semi-conductrice 331 se situent en regard de la troisième portion 212C de la deuxième section de guide d'onde 212 à proximité de la quatrième portion 212D, le milieu à gain 321 et la troisième zone semiconductrice 331 ayant une section latérale de largeur constante et égale à 5µm, cette largeur étant identique à la largeur de leur section latérale dans le guide d'onde hybride 313.

La figure 3B illustre une vue rapprochée d'une première zone de transition optique 312 présentant une configuration alternative à celle décrite ci-dessus. Dans cette configuration alternative, la première surépaisseur 412 présente une forme trapézoïdale isocèle avec ses bases qui s'étendent parallèlement à la direction de propagation de la lumière tandis que la deuxième section de guide d'onde 212 présente une forme fuselée similaire à celle décrite dans le cadre du premier mode de réalisation.

Ainsi comme illustré sur la figure 3B, la deuxième section 212 du guide d'onde comporte, au niveau de son arête:
- sur une première partie de sa longueur une section transversale croissante,
- sur une deuxième partie de sa longueur, une section transversale constante, qui représente une partie majoritaire de la longueur de la deuxième section du guide d'onde,
- sur une dernière partie de sa longueur, une section transversale décroissante.

La première surépaisseur 412 comporte, comme illustré sur la figure 3B, une forme trapézoïdale isocèle avec une première base, dite longue, présentant une longueur supérieure à celle de la deuxième partie de la deuxième section 212, et une base, dite courte, d'une longueur inférieure à celle de la deuxième partie de la deuxième section 212. La première surépaisseur 412 présente une largeur supérieure à celle de l'embase de la deuxième section et inférieure à celle de la structure à gain 310, et notamment de la troisième zone semi-conductrice 331 de la structure à gain 310.

Bien entendu, de manière identique à la première surépaisseur 412 décrite dans le cadre du premier mode de réalisation, l'épaisseur de la première surépaisseur 412 est choisie pour permettre, avec la deuxième section de guide d'onde 212 une transition adiabatique entre le guide d'onde hybride laser 313 et la première section de guide d'onde 211.

La configuration de la structure à gain 310 est sensiblement identique à celle décrites en relation avec la figure 3A.

Ces deux configurations des première et deuxième surépaisseurs 412, 414 et des première et deuxième portions 211, 212 décrites dans le cadre de ce premier mode de réalisation sont données à titre d'exemples de configuration permettant un couplage optimisé entre le guide d'onde hybride 313 et la première section de guide d'onde 211 et ne sont nullement limitatives.

Les figures 4A à 4F illustrent un dispositif photonique 1 selon un deuxième mode de réalisation dans lequel la structure de contre réaction optique 220 est fournie par un réseau de Bragg distribué du type 223 à « corrugations verticales » partiellement gravées dans l'épaisseur de la première couche de silicium 210 au niveau de la troisième section de guide d'onde 213. Un dispositif photonique 1 selon ce deuxième mode de réalisation se différencie du dispositif photonique 1 selon le premier mode de réalisation uniquement par la structure de contre réaction optique 220.

Ainsi, dans ce deuxième mode réalisation, la structure de contre réaction optique 220 est fournie par un réseau de Bragg distribué du type à « corrugations verticales » partiellement gravées dans la première couche de silicium 210, c'est-à-dire que la variation périodique d'indice optique du réseau de Bragg est fournie par une variation de l'épaisseur périodique de la troisième section de guide d'onde 213.

Dans l'application pratique de l'invention, comme illustré par les vues en coupes selon les axes II et JJ montrées sur les figures 4E et 4F, la variation d'épaisseur dans la troisième section de guide d'onde 213 est réalisée sur une deuxième partie de l'épaisseur de la première couche de silicium 210 qui s'étend à partir de la première face 210A de la première couche de silicium 210 et qui présente typiquement une épaisseur de 150 nm. Cette deuxième partie correspond à l'arête de la troisième section de guide d'onde 213. La structure de contre réaction 220 présente une épaisseur variant ainsi sur toute la hauteur de l'arête entre une épaisseur faible, sensiblement nulle, et une épaisseur importante, correspondant à la hauteur de ladite partie de première couche de silicium 210 La période d'alternance entre l'épaisseur faible et l'épaisseur importante, selon le principe d'un réseau de Bragg, est sensiblement égale à λ/2n_{eff}, λ étant la longueur d'onde d'émission du laser 300. La première partie de la première couche de silicium 210 dans la troisième section de guide d'onde 213, selon l'application pratique de l'invention, présente une épaisseur constante et forme l'embase de la troisième section de guide d'onde 213.

Le procédé de fabrication d'un dispositif photonique 1 selon ce deuxième mode de réalisation se différencie du procédé de fabrication d'un dispositif photonique 1 selon le premier mode de réalisation en ce que lors de l'étape de structuration de la première couche de silicium 210, la structure de contre réaction optique 220 formée est un réseau de Bragg à « corrugations verticales » partiellement gravée dans l'épaisseur de la première couche de silicium 210.

Les figures 5A à 5G illustrent, selon une vue en coupe longitudinale, les principales étapes de fabrication d'un dispositif photonique 1 selon un troisième mode de réalisation dans lequel la structure de contre réaction optique 220 est un réseau de Bragg à « corrugations verticales » orientées en direction de la structure à gain 310 et partiellement gravée dans l'épaisseur de la première couche de silicium 210 comprenant la première face 210A de la première couche de silicium 210.. Un dispositif photonique 1 selon ce troisième mode de réalisation se différencie d'un dispositif photonique 1 selon le deuxième mode de réalisation, outre l'orientation de la structure de contre réaction optique 220, en ce qu'il est prévu une troisième couche diélectrique 401 entre la première couche de silicium 210 et les première et deuxième surépaisseurs 412, 414, en ce que les structurations de la première couche de silicium 210 ne sont pas remplies par un matériau diélectrique, et en ce que les structurations de la première couche de silicium 210 sont également reportées dans la première couche diélectrique 110.

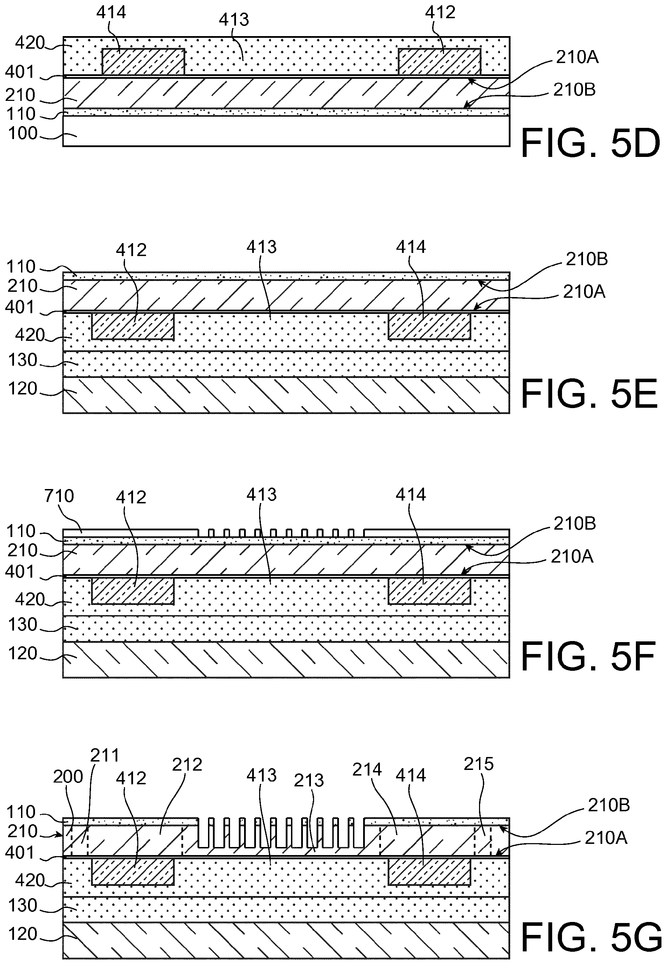

Un procédé de fabrication selon ce troisième mode réalisation comporte les étapes suivantes :
- fourniture du substrat 100 associé avec la première couche de silicium 210 sur la première couche diélectrique 110, comme illustré sur la figure 5A,
- formation d'une troisième couche diélectrique 401 sur la première face de la première couche de silicium 210,
- formation d'une deuxième couche de silicium 410 en contact avec la troisième couche diélectrique 401, comme illustré sur la figure 5B,
- gravure sélective de la deuxième couche de silicium 410 de manière à former la première et la deuxième surépaisseur 412, 414 de silicium recouvrant en regard de respectivement de zones de la première couche de silicium 210 destinées à former la deuxième et la quatrième section de guide d'onde 212, 214, la première et la deuxième surépaisseurs étant séparées par l'espace 413 en regards d'une zone de la première couche de silicium 210 destinée à former la troisième section de guide d'onde 213, comme illustré sur la figure 5C
- enterrement de la première et de la deuxième surépaisseur 412, 414 de silicium et remplissage de l'espace 413 par un matériau diélectrique et planarisation dudit matériau diélectrique afin de former une couche intermédiaire 420 plane, un ensemble substrat 100/ première couche diélectrique/ première couche de silicium 210/ couche intermédiaire 420 étant ainsi formé, comme illustré sur la figure 5D,
- fourniture d'un support 120 comportant une deuxième couche diélectrique 130,
- assemblage de l'ensemble substrat 100/ première couche diélectrique 110/ première couche de silicium 210/ couche intermédiaire 420 sur le support 120, l'assemblage étant réalisé par collage de la couche intermédiaire sur la deuxième couche diélectrique 130 du support 120,
- suppression du substrat 120, comme illustré sur la figure 5E,
- dépôt d'un masque dur 710 par exemple en nitrure de silicium SiN, sur la première couche diélectrique 110 comme illustré sur la figure 5F,
- structuration de la première couche de silicium 210 et de la première couche diélectrique 110 au travers du masque dur 710 de manière à former le guide d'onde 200 et les première à cinquième sections de guide d'onde 211, 212, 213, 214, 215 distinctes du guide d'onde distinctes du guide d'onde 210, la première à la cinquième section de guide d'onde 211, 212, 213, 214, 215 se succédant et étant connectées optiquement au guide d'onde 200 par au moins l'une de la première et la cinquième section de guide d'onde 211, 215, la troisième section de guide d'onde 213 accommodant la structure de contre réaction optique 220, la deuxième, la quatrième et la troisième section de guide d'onde 212, 214, 213 étant en regard de respectivement la première et la deuxième surépaisseur 414, 414 et de l'espace 413,
- suppression du masque dur 710 de manière à libérer la première couche de diélectrique 110, comme illustré sur la figure 5G,
- formation de la structure à gain 310 en contact avec la première couche diélectrique 110, la structure à gain 310 comportant au moins le milieu à gain 321 apte à émettre de la lumière, la structure à gain 310 présentant une portion centrale en regard de l'espace 413 et une première et une deuxième extrémité en regard de la première et la deuxième surépaisseur 412, 414, ainsi, la portion centrale de la structure à gain 310 forme avec l'espace 413 et la troisième section de guide d'onde 213 un guide d'onde hybride laser 313, les deuxième et quatrième section de guide d'onde 212, 214, les première et deuxième surépaisseurs 412, 414 de silicium et les première et deuxième extrémités de la structure à gain 310 formant une première et une deuxième zone de transition optique 312, 314 du mode optique entre le guide d'onde hybride laser 313 et respectivement la première et la cinquième section de guide d'onde 211, 215, comme illustré sur la figure 5H.

On notera que si dans ce procédé il est prévu une étape de formation d'une troisième couche diélectrique 401, cette étape est optionnelle. Ainsi, dans le cas où une telle étape ne serait pas mise en œuvre, la deuxième couche de silicium 410 est alors formée en contact de la première face 210A de la première couche de silicium 210 lors de l'étape de formation de la deuxième couche de silicium 410. Une telle étape facultative de formation d'une troisième couche diélectrique 401 est compatible avec les principaux modes de réalisation de l'invention.

La figure 6 illustre un dispositif photonique 1 selon un quatrième mode de réalisation en fonctionnement et dans lequel il prévu un modulateur optique 230 hybride du type capacitif. Un dispositif photonique 1 selon ce quatrième mode de réalisation se différencie d'un dispositif photonique 1 selon le troisième mode de réalisation en ce que la structure de contre réaction optique 220 comporte, en complément au réseau de Bragg à « corrugations verticales » partiellement gravées dans la première couche de silicium accommodé dans la troisième section de guide d'onde 213, un réflecteur sensiblement total 250 sous la forme d'un réseau de Bragg accommodé dans la première section de guide d'onde 211, et en ce que le guide d'onde 210 accommode un modulateur optique 230 du type capacitif et un réseau de couplage 240 partiellement gravé dans la première couche de silicium 210.

Ainsi on peut voir sur la figure 6, que la première couche de silicium comporte en outre une zone de silicium dopée 232, en relation avec une quatrième zone semi-conductrice 231, et un réseau de couplage 240 pour extraire le rayonnement en sortie du dispositif photonique 1. Le réseau de couplage est un réseau à « corrugations verticales et latérales ».

Le dispositif photonique 1 comporte en outre la quatrième zone semi-conductrice 231 qui, formée du même matériau que la première zone semi-conductrice 341, est en regard de la zone dopée 232. La quatrième zone semi-conductrice 231 est en contact avec la deuxième face de la première couche diélectrique 110. De cette manière, la quatrième zone semi-conductrice 231, la zone de silicium dopée 232 et la partie de la couche diélectrique 110 qui les sépare forment ensemble le modulateur optique 230 hybride de type capacitif.

La première section de guide d'onde 211 accommode également un réseau de Bragg formant un réflecteur sensiblement total 250 ceci afin d'optimiser la sélectivité de la cavité oscillante formée par la structure de contre réaction optique 220.

Le procédé de fabrication d'un dispositif photonique 1 selon ce quatrième mode de réalisation se différencie d'un procédé de fabrication selon le deuxième mode de réalisation en ce que :
- lors de la structuration de la première couche de silicium 210, il est également formé le réseau de couplage 240 accommodé dans le guide d'onde 200 et un réseau de Bragg, formant le réflecteur sensiblement total 250, accommodé dans la première section de guide d'onde 211,
- il est prévu une étape de dopage localisé de la première couche de silicium 210 afin de former la zone de silicium dopée 232 d'un type de conducivité opposée au type de conductivité de la quatrième zone semi-conductrice 231 et
- lors de la formation de la structure à gain 310, il est également formé la quatrième zone semi-conductrice 231 en regard de la zone dopée 232 afin de former le modulateur capacitif 230.

Les figures 7A et 7B illustrent schématiquement deux vue en coupe selon les axes LL et MM d'un dispositif selon ce quatrième mode de réalisation dans lequel il a été ajouté un exemple d'agencement d'un premier à un quatrième contact électrique 531, 532, 533, 534 côté substrat 120 dans le cadre d'un dispositif photonique selon ce quatrième mode de réalisation. On notera que ces figures 7A et 7B illustrent également une couche d'encapsulation 510 de la structure à gain 310 et la quatrième zone semi-conductrice 231 est réalisée dans un matériau diélectrique.

La figure 7A illustre plus précisément les premier et deuxième contacts électriques 531, 532 en lien avec la structure à gain 310. Ces premier et deuxième contacts électriques 531, 532 sont réparties de part et d'autre de la structure à gain 310 selon une direction transversale à la structure de contre réaction optique 220 pour connecter respectivement la première et la troisième zone semi-conductrice 331, 341. Plus précisément le premier et le deuxième contact électrique 531, 532 comportent chacun un contact métallique respectif en contact avec respectivement la surface de la première et de la troisième zone semi-conductrice 331, 341 et adapté pour former avec cette dernière zone semi-conductrice 331, 341 un contact ohmique. Le premier et le deuxième contact électrique 531, 532 comportent chacun en outre un via métallique respectif traversant la première couche diélectrique 110, la couche intermédiaire 420 et le support 120 comprenant la couche 130. Chacun des via métalliques des premier et deuxième contacts électriques 531, 532 débouche sur la surface du support 120 afin d'autoriser une prise de contact avec un circuit de commande, non illustré, du laser 300.

La figure 7B illustre les troisième et quatrième contacts électriques 533, 534 en lien avec le modulateur optique 230. Le troisième contact électrique 533 permet de connecter la quatrième zone semi-conductrice 231 du modulateur optique 230 et présente une configuration similaire au premier et au deuxième contact électrique 531, 532. Ainsi le troisième contact électrique 533 comporte un contact métallique en contact avec la surface de la quatrième zone semi-conductrice 231 et adapté pour former avec celle-ci un contact ohmique. Le troisième contact électrique 533 comporte en outre un via métallique respectif traversant la première couche diélectrique 110, la couche intermédiaire 420 et le support 120. Le quatrième contact électrique 534 comporte un via métallique en contact avec la surface de la zone dopée 232 en formant avec cette dernière un contact ohmique. Les via respectifs du troisième et du quatrième contact électrique 533, 534 débouchent chacun sur la surface du support 120 afin d'autoriser une prise de contact avec un circuit de commande, non illustré, du modulateur optique 230.

Bien entendu, selon le même principe et dans le cas où le guide d'onde 200 accommode d'autres composants optiques actifs, tels que par exemple un multiplexeur et un démultiplexeur, le dispositif photonique 1 peut comporter des via métalliques complémentaires traversant la première couche diélectrique 110, la couche intermédiaire 420 et le support 120 et débouchant sur la surface du support 120 afin d'autoriser une prise de contact avec le circuit de commande de ces mêmes composants optiques actifs. Ce circuit de commande, de la même façon que les circuits de commande du laser 300 et du modulateur optique 230 peut être un circuit de commande exclusif desdits composants optiques actifs ou un circuit de commande commun avec le modulateur optique 230 et/ou le laser 300. Ainsi le circuit de commande laser 300 et le circuit de commande du modulateur optique 230 peuvent donc être tous deux fournis par un unique circuit de commande du dispositif photonique 1.

Avec une telle configuration des premier au quatrième contacts électriques 531, 532, 533, 534, il est possible de commander les différents composants du dispositif photonique 1 selon le quatrième mode de réalisation, ceci en le connectant à un circuit commande sur sa face côté support 120.

Les figures 8A et 8B illustrent schématiquement un deuxième exemple d'agencement d'un premier à un quatrième contact électrique 531, 532, 533, 534 côté couche d'encapsulation 510 dans le cadre d'un dispositif photonique 1 selon le quatrième mode de réalisation. De la même façon que la possibilité illustrée sur le figures 7A et 7B, le dispositif photonique 1 tel qu'illustré sur les figures 8A et 8B comporte ainsi également une couche d'encapsulation 510 permettant d'encapsuler la structure à gain 310 et la quatrième zone semi-conductrice 231.

On peut voir sur la figure 8A, que le premier contact électrique 531 est constitué d'un contact métallique latéral en contact avec la surface de la troisième zone semi-conductrice 341 et adapté pour former avec celle-ci un contact ohmique. Le contact métallique latéral du premier contact électrique 531 débouche dans une deuxième face de la couche d'encapsulation 510 qui est opposée à la première couche diélectrique 110. Le deuxième contact électrique 532 comporte un contact métallique pour contacter la première zone semi-conductrice 331 et adapté pour former un contact ohmique avec cette dernière. Le deuxième contact électrique 532 comporte en outre un via métallique en contact avec le contact métallique et traversant la couche d'encapsulation 510 en débouchant sur la deuxième face de la couche d'encapsulation 510.

La figure 8B illustre les troisième et quatrième contacts électriques 533, 534 en lien avec le modulateur optique 230. Le troisième contact électrique 253 permet de connecter la quatrième zone semi-conductrice 231 du modulateur optique 230 et présente une configuration similaire au deuxième contact électrique 532. Ainsi le troisième contact électrique 533 comporte un contact métallique en contact avec la surface de la quatrième zone semi-conductrice 231 et adapté pour former avec celle-ci un contact ohmique. Le troisième contact électrique 533 comporte en outre un via métallique traversant la couche d'encapsulation 510. Le via métallique du troisième contact électrique 533, débouche sur la deuxième face de la couche d'encapsulation 510. Le quatrième contact électrique 254 comporte un via métallique en contact avec la surface de la zone dopée 232 en formant avec cette dernière un contact ohmique et traversant la première couche diélectrique 110 et la couche d'encapsulation 510 en débouchant dans la deuxième face de cette dernière. Les via métalliques respectifs du troisième et du quatrième contact électrique 532, 534 en débouchant chacun sur la deuxième face de la couche d'encapsulation 510 autorisent une prise de contact avec un circuit de commande, non illustré, du dispositif photonique 1.

La figure 9 montre une vue de dessus et une vue en coupe longitudinale selon l'axe NN d'un dispositif photonique 1 selon un cinquième mode de réalisation dans lequel la structure de contre réaction optique 220 est formée par un premier et un deuxième réseau de Bragg 221, 222 accommodés respectivement dans la première et la cinquième section de guide d'onde 211, 215. Le dispositif photonique 1 selon ce cinquième mode de réalisation se différencie d'un dispositif photonique 1 selon le premier mode de réalisation tel qu'illustré par les figures 1A à 1F en ce que la structure de contre réaction est formée par le premier et le deuxième réseau de Bragg 221, 222 accommodé respectivement dans la première et la cinquième section de guide d'onde 211, 215.

Comme illustré sur la figure 9, la structure de contre réaction est formée par un premier et un deuxième réseau de Bragg 221, 222 du type « à corrugations verticales » partiellement gravées dans l'épaisseur de la première couche de silicium 210 accommodés respectivement dans la première et la cinquième section de guide d'onde 211, 215. Le premier et le deuxième réseau de Bragg 221, 222 sont du même type que celui de la structure de contre réaction optique 220 du dispositif photonique 1 selon le quatrième mode de réalisation illustré sur la figure 6. Le premier et le deuxième réseau de Bragg sont séparés l'un de l'autre d'une distance adaptée pour former une cavité oscillante comprenant le milieu à gain 321. De cette manière le laser 300 est un laser à cavité délimitée à ses deux extrémités par deux réseaux de Bragg distribués, plus connu sous la dénomination anglaise « distributed Bragg reflector laser » et son sigle laser DBR. Dans une telle configuration, la deuxième et la quatrième section de guide d'onde 212, 214 sont disposées à l'intérieur de la cavité oscillante délimitée par les premier et deuxième réseaux de Bragg 221, 222.

Les figures 10A et 10B illustrent respectivement des vues rapprochées des première et deuxième sections de guide d'onde 211, 212 d'un dispositif photonique 1 selon respectivement un sixième et un septième mode de réalisation dans lequel le premier et le deuxième réseaux de Bragg 221, 222 sont accommodés dans, pour le sixième mode de réalisation, la deuxième et la quatrième section de guide d'onde 212, 214, et pour le septième mode de réalisation, la première et la deuxième surépaisseur 412, 413.

Ainsi, comme montré sur la vue de dessus et la vue en coupe longitudinale selon l'axe OO de la figure 10A, le dispositif photonique 1 selon le sixième mode de réalisation se différencie d'un dispositif photonique selon le cinquième mode de réalisation en ce que le premier et le deuxième réseau de Bragg 221, 222 sont respectivement formés dans la deuxième et quatrième section de guide d'onde 212, 214 et en ce que le premier et le deuxième réseaux de Bragg sont des réseaux de Bragg à « corrugation latérales » partiellement gravés dans l'épaisseur de la première couche de silicium 210.

Comme illustré sur la figure 10A, le premier et le deuxième réseau de Bragg 221, 221 sont accommodées dans la deuxième et la quatrième section de guide d'onde 212, 214 dans une portion de ces dernière qui présente une section latérale qui, en l'absence des corrugation formant ledit réseau de Bragg, est sensiblement constante. Le premier et du deuxième réseau de Bragg 221, 222 sont, selon le principe décrit dans le cadre du premier mode de réalisation, des réseaux de Bragg distribués à « corrugations latérales » partiellement gravées dans la première couche de silicium 210.

Le procédé de fabrication du dispositif photonique 1 selon ce sixième mode de réalisation se différencie du procédé de fabrication du dispositif optique selon le premier mode de réalisation en ce que lors de l'étape de structuration de la première couche de silicium 210, la première couche de silicium est structurée afin de former le premier et le deuxième réseau de Bragg 221, 222 accommodés dans respectivement la deuxième et la quatrième section de guide d'onde 212, 214 et en ce qu'il n'est pas formé de réseau de Bragg dans la troisième section de guide d'onde 213.

Le dispositif optique 1 selon le septième mode de réalisation, illustré par la vue de dessus et la vue en coupe longitudinale selon l'axe PP montré sur la figure 10B, se différencie d'un dispositif optique 1 selon le cinquième mode de réalisation en ce que le premier et le deuxième réseau de Bragg 221, 222 sont respectivement formé dans la première et la deuxième surépaisseur 412, 414 et en ce que le premier et le deuxième réseau de Bragg 221, 222 sont des réseaux de Bragg à « corrugation verticale » totalement gravés dans l'épaisseur de la première et la deuxième surépaisseur 412, 414.

Comme illustré sur la figure 10B et de manière similaire au dispositif photonique 1 selon le sixième mode de réalisation, le premier et le deuxième réseau de Bragg 221, 221 sont accommodées dans la première et la deuxième surépaisseur 412, 414 dans une portion de ces dernière qui présente une section latérale qui, en l'absence des corrugation formant ledit réseau de Bragg, est sensiblement constante. Le premier et le deuxième réseau de Bragg 221, 222, selon un principe similaire à celui décrit dans le cadre du deuxième mode de réalisation, sont des réseaux de Bragg distribués à « corrugations verticales ». Les premier et deuxième réseaux de Bragg sont gravés totalement dans lesdites première et deuxième surépaisseurs 412, 414.

Le procédé de fabrication du dispositif photonique 1 selon ce septième mode de réalisation se différencie du procédé de fabrication du dispositif optique selon le sixième mode de réalisation en ce que lors de l'étape de structuration de la première couche de silicium 210, il n'y a pas formation de réseaux de Bragg et en ce que lors de l'étape de formation de la première et de la deuxième surépaisseur 412, 414, la première et la deuxième surépaisseur 412, 414 accommodent respectivement le premier et le deuxième réseau de Bragg 221, 222.

Les figures 11A à 11C illustrent une vue de dessus et des vues en coupe longitudinale et latérale selon les axes QQ et RR d'un dispositif photonique selon un huitième mode de réalisation dans lequel la structure à gain 310 est du type à « jonction latérale ». Un dispositif selon ce huitième mode de réalisation se différencie d'un dispositif phonique 1 selon le deuxième mode de réalisation en ce que la structure à gain 310 est une structure à gain du type à « jonction latérale » et en ce que le guide d'onde 200 est réalisé pour une partie dans la première couche de silicium 210 et pour le reste dans au moins une troisième surépaisseur 402 de silicium.

Comme illustré sur les figures 11A et 11B , le guide d'onde 200 est en partie aménagé dans la première couche de silicium 210 et au moins une troisième surépaisseur 402 de silicium qui se prolonge uniquement au niveau de la premiere extrémité de la structure à gain 310 par la première surépaisseur 412 de silicium. On notera en particulier que la troisième surépaisseur 402 de silicium recouvre la première sectios de guide d'onde 211.

La structure à gain 310 comporte, comme illustré sur la figure 11C successivement et selon une coupe transversale du guide d'onde hybride 313 le long de l'axe RR :
- une première zone semi-conductrice 341 d'un premier type de conductivité,
- une deuxième zone semi-conductrice, comportant un empilement constitué d'au moins une couche de puit quantique, ou de boites quantiques, et de couches de confinement, la deuxième zone semiconductrice formant le milieu à gain 321,
- une troisième zone semi-conductrice 331 d'un deuxième type de conductivité opposé au premier type de conductivité de la zone semi-conductrice 341.

La structure à gain 310 comporte en outre, comme illustré sur les figures 11A à 11C, une première et une deuxième zone de couplage 351, 352 non intentionnellement dopée disposées de part et d'autre des première, deuxième et troisième zones semi-conductrices 341, 331 selon la direction de propagation de la lumière, et une couche semi-conductrice 353, également non intentionnellement dopée, s'interposant entre la première couche diélectrique et le reste de la structure à gain 310. La première et la deuxième zone de couplage 351, 352 correspondent ainsi chacune à une extrémité de la structure à gain 310 par l'intermédiaire desquelles la première et la deuxième zone de transition optique 312, 314 permettent une transmission adiabatique du mode optique entre le guide d'onde hybride laser 313 et respectivement la première et la cinquième section de guide d'onde 211, 215.

Le procédé de fabrication d'un dispositif photonique selon ce sixième mode de réalisation de l'invention se différencie du procédé de fabrication selon le deuxième mode de réalisation de l'invention en ce que :
- il comporte en outre une étape de formation d'au moins une troisième surépaisseur 402 de silicium recouvrant les parties de la couche de silicium 210 comprises ou étant destinées à être comprises dans le guide d'onde 200 et qui ne sont pas destinées à être recouvertes par la zone centrale de la structure à gain 310 et par la première et la deuxième surépaisseur 412, 414,
- et en ce que lors de l'étape de formation de la structure à gain 310, la structure à gain est une structure à « jonction latérale ».

Bien entendu, si une configuration selon ce huitième mode de réalisation est particulièrement avantageuse pour un dispositif photonique comportant une structure à gain 310 du type à « jonction latérale », il est également parfaitement envisageable de prévoir un dispositif photonique comportant une telle structure à gain 310 avec une configuration de l'un quelconque des modes de réalisation précédemment décrits. Avec une telle configuration, il n'est donc pas réalisé une troisième surépaisseur 402 participant à la formation du guide d'onde 200. De la même façon, il est parfaitement envisageable qu'un dispositif comportant une structure à gain 310 du type à « jonction verticale » puisse également comprendre une telle troisième surépaisseur 402.

On notera également qu'en variante non illustrée à une telle troisième surépaisseur 402, il est également envisageable, sans que l'on sorte du cadre de l'invention, que l'aménagement du guide d'onde 200 soit un aménagement d'une première partie de l'épaisseur du guide d'onde 200 dans la première couche de silicium 210 et d'une deuxième partie de l'épaisseur du guide d'onde 200 dans une cinquième surépaisseur réalisées dans un matériau de la structure à gain 310, ou encore que cette aménagement soit une combinaison d'au moins deux aménagements parmi :
- un aménagement du guide d'onde 200 en totalité dans la première couche de silicium 210,
- un aménagement d'une première partie de l'épaisseur du guide d'onde 200 dans la première couche de silicium 210 et d'une deuxième partie de l'épaisseur du guide d'onde 200 dans une troisième surépaisseur 402 de silicium,
- un aménagement d'une première partie de l'épaisseur du guide d'onde 200 dans la première couche de silicium 210 et d'une deuxième partie de l'épaisseur du guide d'onde 200 dans une cinquième surépaisseur réalisée dans un matériau de la structure à gain 310.

Bien entendu, si dans l'ensemble des modes de réalisation décrits ci-dessus, la structure à gain présente une forme rectangulaire, d'autres forme de la structure à gain sont parfaitement envisageable sans que l'on sorte du cadre de l'invention. Ainsi, par exemple, l'homme du métier est à même de comprendre que les extrémités de la structure à gain peuvent également avoir une forme fuselée, c'est-à-dire que certaines ou toutes les couches constituant la structure à gain peuvent s'amincir en partant de la partie centrale et en allant vers le bord en suivant un axe longitudinal de la structure à gain. Cette forme de chacune des extrémités de la structure à gain peut être, entre autre exemple, trapézoïdale.

## Revendications

1. Dispositif photonique (1) comportant :
- un support (120),
- une couche intermédiaire (420) en contact avec le support (120) et comportant au moins un matériau diélectrique et une première et une deuxième surépaisseur de silicium (412, 414), la première et la deuxième surépaisseur (412, 414) de silicium étant séparées l'une de l'autre par un espace (413)
- une première couche de silicium (210) en contact avec la couche intermédiaire (420) à l'opposé du support (120), la première couche de silicium (210) comportant au moins une partie de l'épaisseur d'un guide d'onde (200), et une première à une cinquième section de guide d'onde (211, 212, 213, 214, 215) distinctes du guide d'onde (200), la première à la cinquième section de guide d'onde (211, 212, 213, 214, 215) se succédant et étant connectées optiquement au guide d'onde (200) par au moins l'une de la première et de la cinquième section de guide d'onde (211, 215), la deuxième, la quatrième et la troisième section de guide d'onde (212, 214, 213) étant en regard de respectivement la première et la deuxième surépaisseur (414, 414) et de l'espace (413),
- une première couche de diélectrique (110) recouvrant la première couche de silicium (210) à l'opposé de à la couche intermédiaire (420),
- une structure à gain (310) comportant au moins un milieu à gain (321) apte à émettre de la lumière, la structure à gain (310) présentant une portion centrale en regard de l'espace (413) et une première et une deuxième extrémité en regard de la première et la deuxième surépaisseur (412, 414), ainsi, la portion centrale de la structure à gain (310) forme avec l'espace (413) et la troisième section de guide d'onde (213) un guide d'onde hybride laser (313), les deuxième et quatrième section de guide d'onde (212, 214), les première et deuxième surépaisseurs (412, 414) de silicium et les premières et deuxième extrémités de la structure à gain (310) formant une première et une deuxième zone de transition optique (312, 314) d'un mode optique entre le guide d'onde hybride laser (313) et respectivement la première et la cinquième section de guide d'onde (211, 215),
- une structure de contre réaction (220) pour former une cavité oscillante comprenant au moins une partie du milieu à gain (321) de manière à former un laser (300) connecté optiquement au guide d'onde (200) par au moins l'une de la première et la cinquième section de guide d'onde (211, 215).

2. Dispositif photonique (1) selon la revendication 1 dans lequel la troisième section de guide d'onde (213) accommode un réflecteur distribué (223) formant la structure de contre réaction (220).

3. Dispositif photonique (1) selon la revendication 2, dans lequel le réflecteur distribué (223) est un réseau de Bragg distribué sélectionné dans le groupe comportant les réseaux de Bragg distribués à corrugations latérales partiellement gravées dans une épaisseur de la première couche de silicium (210), les réseaux de Bragg distribués à corrugations latérales totalement gravées dans l'épaisseur de la première couche de silicium (210), les réseaux de Bragg distribués à corrugations verticales partiellement gravées dans l'épaisseur de la première couche de silicium (210) et les réseaux de Bragg distribués à corrugations verticales totalement gravées dans l'épaisseur de la première couche de silicium (210).

4. Dispositif photonique (1) selon la revendication 3, dans lequel le réflecteur distribué 223 est sélectionné dans le groupe comportant les réseaux de Bragg distribué à corrugations latérales partiellement gravées dans une épaisseur de la première couche de silicium et les réseaux de Bragg distribué à corrugations verticales partiellement gravées dans l'épaisseur de la première couche de silicium,
et dans lequel la partie de l'épaisseur de la première couche de silicium (210) dans laquelle les corrugations sont gravées est la partie de l'épaisseur de la première couche de silicium (210) qui est opposée à la première couche diélectrique (110) et à la structure à gain (310).

5. Dispositif photonique (1) selon la revendication 1, dans lequel la première et la cinquième section de guide d'onde (211, 215) accommodent respectivement un premier et un deuxième miroir (221, 222) de manière à former une cavité oscillante comportant le milieu à gain (321), le premier et deuxième miroir formant la structure de contre réaction (220).

6. Dispositif photonique (1) selon la revendication 1, dans lequel la deuxième et la quatrième section de guide d'onde (212, 214) accommodent respectivement un premier et deuxième réseau de Bragg distribués (221, 222) de manière à former une cavité oscillante comportant le milieu à gain (321), le premier et deuxième réseaux de Bragg distribués formant la structure de contre réaction (220).

7. Dispositif photonique (1) selon la revendication 1 ou 6 dans lequel la première et la deuxième surépaisseur (411, 414) accommodent respectivement un premier et deuxième réseau de Bragg distribués (221, 222) de manière à former une cavité oscillante comportant le milieu à gain (321), le premier et deuxième réseau de Bragg distribué formant la structure de contre réaction (220).

8. Dispositif photonique (1) selon l'une quelconque des revendications 1 à 7 dans lequel la structure à gain (310) est choisie dans le groupe comportant les structures à gain du type à « jonction verticale » et les structures à gain du type à « jonction latérale ».

9. Dispositif photonique (1) selon l'une quelconque des revendications 1 à 8, dans lequel l'aménagement du guide d'onde (200) est choisi parmi:
- un aménagement du guide d'onde (200) en totalité dans la première couche de silicium (210),
- un aménagement d'une première partie de l'épaisseur du guide d'onde (200) dans la première couche de silicium (210) et d'une deuxième partie de l'épaisseur du guide d'onde (200) dans une troisième surépaisseur (402) de silicium,
- un aménagement d'une première partie de l'épaisseur du guide d'onde (200) dans la première couche de silicium (210) et d'une deuxième partie de l'épaisseur du guide d'onde (200) dans une cinquième surépaisseur réalisée dans un matériau de la structure à gain (310)
- une combinaison d'au moins deux des aménagements précités.

10. Dispositif photonique (1) selon l'une quelconque des revendications 1 à 9, dans lequel le premier guide d'onde (200) accommode au moins un composant optique, le composant optique étant préférentiellement choisi dans le groupe comportant les modulateurs optiques silicium à jonction PN, les modulateurs hybrides semi-conducteur III-V sur silicium, les réseaux de couplage surfaciques, les coupleurs par la tranche, les filtres optiques, les multiplexeurs et démultiplexeurs en longueurs d'onde, et les photodétecteurs dont font partie les photodétecteurs germanium sur silicium et les photodétecteurs semi-conducteur III-V sur silicium.

11. Dispositif photonique (1) selon l'une quelconque des revendications 1 à 10 dans lequel la première et la deuxième surépaisseur (412, 414) de silicium sont chacune réalisées en un silicium sélectionné parmi un silicium mono-cristallin, un silicium amorphe, et un silicium poly-cristallin.

12. Procédé de fabrication d'un dispositif photonique (1) comportant au moins un guide d'onde en silicium (200) et un laser (300) comprenant un milieu à gain (321) apte à émettre de la lumière, le procédé comportant les étapes suivantes :
- fourniture d'un substrat (100) associé avec une première couche de silicium (210) sur une première couche diélectrique (110),
- structuration de la première couche de silicium (210) pour former dans la première couche de silicium (210) au moins une partie d'épaisseur d'un guide d'onde (200) et des première à cinquième sections de guide d'onde (211, 212, 213, 214, 215) distinctes du guide d'onde distinctes du guide d'onde (200), la première à la cinquième section de guide d'onde (211, 212, 213, 214, 215) se succédant et étant connectées optiquement au guide d'onde (200) par au moins l'une de la première et la cinquième section de guide d'onde (211, 215),
- formation d'une première et d'une deuxième surépaisseur (412, 414) de silicium séparée l'une de l'autre par un espace (413), la première et la deuxième surépaisseur (412, 414) et l'espace (413) étant en regard de respectivement les deuxième, quatrième et troisième sections de guide d'onde (212, 214, 213)ou de zones de la première couche de silicium (210) destinées à les formées,
- enterrement d'au moins la première et de la deuxième surépaisseur (412, 414) de silicium par au moins un matériau diélectrique et planarisation dudit matériau diélectrique afin de former une couche intermédiaire (420), un ensemble substrat (100)/ première couche diélectrique (110)/ première couche de silicium (210)/ couche intermédiaire (420) étant ainsi formé,
- fourniture d'un support (120),
- assemblage de l'ensemble substrat (100)/ première couche diélectrique (110)/ première couche de silicium (210)/ couche intermédiaire (420) sur le support (120), l'assemblage étant réalisé par collage de la couche intermédiaire sur le support (120),
- suppression du substrat (100),
- formation d'une structure à gain (310) comportant au moins le milieu à gain (321), la structure à gain (310) étant formée en contact avec la première couche diélectrique (110) en présentant une portion centrale de la structure à gain (310) en regard de l'espace (413) et une première et une deuxième extrémité en regard de la première et la deuxième surépaisseur (411, 412), ainsi, la portion centrale de la structure à gain (310) forme avec l'espace (413) et la troisième section de guide d'onde (213) un guide d'onde hybride laser (313), les deuxième et quatrième section de guide d'onde (212, 214), les première et deuxième surépaisseurs (412, 414) de silicium, et les première et deuxième extrémités de la structure à gain (310) formant une première et une deuxième zone de transition optique (312, 314) d'un mode optique entre le guide d'onde hybride laser (313) et respectivement la première et la cinquième sections de guide d'onde (211,215), le dispositif photonique (1) étant ainsi formé,
et dans lequel il est en outre formé une structure de contre réaction (220) pour former une cavité oscillante comprenant au moins en partie le milieu à gain et ainsi former un laser (300) connecté optiquement au guide d'onde (200) par au moins l'une de la première et la cinquième section de guide d'onde (211, 215) lors de l'au moins une des étapes parmi l'étape de structuration de la première couche de silicium (210) et de l'étape de formation de la première et de la deuxième surépaisseur (412, 414) de silicium.

13. Procédé de fabrication selon la revendication 12, dans lequel l'étape de structuration de la première couche de silicium (210) est préalable à l'étape de formation des première et deuxième surépaisseurs (412, 414) de silicium.

14. Procédé de fabrication selon la revendication 12, dans lequel l'étape de structuration de la première couche de silicium (210) est postérieure à l'étape de suppression du substrat (100) et dans lequel l'étape de structuration de la première couche de silicium (210) est une étape de structuration de la première couche de silicium (210) et de la première couche de diélectrique (110).

15. Procédé de fabrication selon l'une quelconque des revendications 12 à 14, dans lequel il est en outre prévu une étape d'amincissement de la première couche diélectrique (110) entre les étapes de suppression du substrat (100) et de formation de la structure à gain (310).

16. Procédé selon l'une quelconque des revendications 12 à 15, dans lequel l'étape de formation de la première et la deuxième surépaisseur (412, 414) de silicium est sélectionnées dans le groupe d'étapes de formation suivantes :
- dépôt sélectif de silicium en contact de la première couche de silicium pour former la première et la deuxième (412, 414) surépaisseur de silicium,
- dépôt d'une deuxième couche de silicium (410) et gravure localisée de la deuxième couche de silicium (410) pour former la première et la deuxième (412, 414) surépaisseur de silicium,
- assemblage d'une deuxième couche de silicium sur la première couche de silicium (210) et gravure localisée de la deuxième couche de silicium (410) pour former la première et la deuxième (412, 414) surépaisseur de silicium.

17. Procédé de fabrication selon l'une quelconque des revendications 12 à 16, comportant en outre l'étape suivante :
- formation d'au moins une troisième surépaisseur (402) de silicium recouvrant des parties de la première couche de silicium (210) structurées ou destinée à être structurées, la troisième section de guide d'onde (213) restant libre de surépaisseur de silicium supplémentaire (201),
et dans lequel l'au moins une troisième surépaisseur (402) de silicium fait partie du guide d'onde (200).

## Patentansprüche

1. Photonische Vorrichtung (1), umfassend:
- einen Träger (120)
- eine Zwischenschicht (420) in Kontakt mit dem Träger (120) und umfassend wenigstens ein dielektrisches Material sowie eine erste und eine zweite Verdickung aus Silizium (412, 414), wobei die erste und die zweite Verdickung (412, 414) aus Silizium voneinander durch einen Zwischenraum (413) separiert sind,
- eine erste Siliziumschicht (210) in Kontakt mit der Zwischenschicht (420) entgegengesetzt zu dem Träger (120), wobei die erste Siliziumschicht (210) wenigstens einen Teil der Dicke eines Wellenleiters (200) umfasst, und einen ersten bis einen fünften unterschiedlichen Wellenleiterabschnitt (211, 212, 213, 214, 215) des Wellenleiters (200), wobei der erste bis der fünfte Wellenleiterabschnitt (211, 212, 213, 214, 215) aufeinander folgen und optisch mit dem Wellenleiter (200) durch wenigstens einen von dem ersten und dem fünften Wellenleiterabschnitt (211, 215) verbunden sind, wobei der zweite, der vierte und der dritte Wellenleiterabschnitt (212, 214, 213) jeweils gegenüber der ersten und der zweiten Verdickung (414, 414) und dem Zwischenraum (413) sind,
- eine erste Dielektrikumsschicht (110), die die erste Siliziumschicht (210) entgegengesetzt zu der Zwischenschicht (420) bedeckt,
- eine Verstärkungsstruktur (310), umfassend wenigstens ein Verstärkungsmilieu (321), das dazu ausgelegt ist, Licht zu emittieren, wobei die Verstärkungsstruktur (310) einen zentralen Bereich gegenüber dem Zwischenraum (413) sowie ein erstes und ein zweites Ende gegenüber der ersten und der zweiten Verdickung (412, 414) aufweist, derart, dass der zentrale Bereich der Verstärkungsstruktur (310) mit dem Zwischenraum (413) und dem dritten Wellenleiterabschnitt (213) einen Hybridlaserwellenleiter (313) bildet, wobei der zweite und der vierte Wellenleiterabschnitt (212, 214), die erste und die zweite Verdickung (412, 414) aus Silizium und das erste und das zweite Ende der Verstärkungsstruktur (310) eine erste und eine zweite optische Übergangszone (312, 314) einer optischen Mode zwischen dem Hybridlaserwellenleiter (313) und jeweils dem ersten bis dem fünften Wellenleiterabschnitt (211, 215) bilden,
- eine Gegenreaktionsstruktur (220) zum Bilden eines Oszillationshohlraums, umfassend wenigstens einen Teil des Verstärkungsmilieus (321) derart, dass ein Laser (300) gebildet wird, der optisch mit dem Wellenleiter (200) durch wenigstens einen von dem ersten und dem fünften Wellenleiterabschnitt (211, 215) verbunden ist.

2. Photonische Vorrichtung (1) nach Anspruch 1, wobei der dritte Wellenleiterabschnitt (213) einen verteilten Reflektor (223) aufnimmt, der die Gegenreaktionsstruktur (220) bildet.

3. Photonische Vorrichtung (1) nach Anspruch 2, wobei der verteilte Reflektor (223) ein verteiltes Bragg-Gitter ist, ausgewählt aus der Gruppe umfassend die verteilten Bragg-Gitter mit lateralen Korrugationen, die partiell in eine Dicke der ersten Siliziumschicht (210) geätzt sind, die verteilten Bragg-Gitter mit lateralen Korrugationen, die vollständig in die Dicke der ersten Siliziumschicht (210) geätzt sind, die verteilten Bragg-Gitter mit vertikalen Korrugationen, die partiell in die Dicke der ersten Siliziumschicht (210) geätzt sind, und die verteilten Bragg-Gitter mit vertikalen Korrugationen, die vollständig in die Dicke der ersten Siliziumschicht (210) geätzt sind.

4. Photonische Vorrichtung (1) nach Anspruch 3, bei der der verteilte Reflektor (223) ausgewählt ist aus der Gruppe umfassend die verteilten Bragg-Gitter mit lateralen Korrugationen, die partiell in eine Dicke der ersten Siliziumschicht geätzt sind, und die verteilten Bragg-Gitter mit vertikalen Korrugationen, die partiell in die Dicke der ersten Siliziumschicht geätzt sind,
und wobei der Teil der Dicke der ersten Siliziumschicht (210), in die die Korrugationen geätzt sind, der Teil der Dicke der ersten Siliziumschicht (210) ist, der entgegengesetzt ist zu der ersten dielektrischen Schicht (110) und zu der Verstärkungsstruktur (310).

5. Photonische Vorrichtung (1) nach Anspruch 1, wobei der erste und der fünfte Wellenleiterabschnitt (211, 215) einen ersten beziehungsweise einen zweiten Spiegel (221, 222) derart aufnehmen, dass ein Oszillationshohlraum gebildet wird, der das Verstärkungsmilieu (321) umfasst, wobei der erste und der zweite Spiegel die Gegenreaktionsstruktur (220) bilden.

6. Photonische Vorrichtung (1) nach Anspruch 1, wobei der zweite und der vierte Wellenleiterabschnitt (212, 214) ein erstes beziehungsweise ein zweites verteiltes Bragg-Gitter (221, 22) derart aufnehmen, dass ein Oszillationshohlraum gebildet wird, der das Verstärkungsmilieu (321) umfasst, wobei das erste und das zweite verteilte Bragg-Gitter die Gegenreaktionsstruktur (220) bilden.

7. Photonische Vorrichtung (1) nach Anspruch 1 oder 6, wobei die erste und die zweite Verdickung (411, 414) ein erstes beziehungsweise ein zweites verteiltes Bragg-Gitter (221, 222) derart aufnehmen, dass ein Oszillationshohlraum gebildet wird, der das Verstärkungsmilieu (321) umfasst, wobei das erste und das zweite verteilte Bragg-Gitter die Gegenreaktionsstruktur (220) bilden.

8. Photonische Vorrichtung (1) nach einem der Ansprüche 1 bis 7, wobei die Verstärkungsstruktur (310) ausgewählt ist aus der Gruppe umfassend die Verstärkungsstrukturen vom Typ "vertikaler Übergang" und die Verstärkungsstrukturen vom Typ "lateraler Übergang".

9. Photonische Vorrichtung (1) nach einem der Ansprüche 1 bis 8, wobei die Anordnung des Wellenleiters (200) ausgewählt ist aus:
- einer Anordnung des Wellenleiters (200) vollständig in der ersten Siliziumschicht (210),
- einer Anordnung eines ersten Teils der Dicke des Wellenleiters (200) in der ersten Siliziumschicht (210) und eines zweiten Teils der Dicke des Wellenleiters (200) in einer dritten Verdickung (402) aus Silizium,
- einer Anordnung eines ersten Teils der Dicke des Wellenleiters (200) in der ersten Siliziumschicht (210) und eines zweiten Teils der Dicke des Wellenleiters (200) in einer fünften Verdickung, die in einem Material der Verstärkungsstruktur (310) realisiert ist,
- einer Kombination von wenigstens zwei der genannten Anordnungen.

10. Photonische Vorrichtung (1) nach einem der Ansprüche 1 bis 9, wobei der erste Wellenleiter (200) wenigstens eine optische Komponente aufnimmt, wobei die optische Komponente vorzugsweise ausgewählt ist aus der Gruppe umfassend die optischen Siliziummodulatoren mit PN-Übergang, die Halbleiterhybridmodulatoren III-V auf Silizium, die Oberflächenkopplungsgitter, die Randkoppler, die optischen Filter, die Wellenlängenmultiplexierer und -demultiplexierer, und die Photodetektoren, wozu die Photodetektoren mit Germanium auf Silizium und die Photodetektoren mit Halbleiter III-V auf Silizium gehören.

11. Photonische Vorrichtung (1) nach einem der Ansrüche 1 bis 10, wobei die erste und die zweite Verdickung (412, 414) aus Silizium jeweils aus einem Silizium realisiert sind, das ausgewählt ist aus einem monokristallinen Silizium, einem amorphen Silizium, und einem polykristallinen Silizium.

12. Verfahren zur Herstellung einer photonischen Vorrichtung (1), umfassend wenigstens einen Wellenleiter aus Silizium (200) und einen Laser (300), umfassend ein Verstärkungsmilieu (321), das dazu ausgelegt ist, Licht zu emittieren, wobei das Verfahren die folgenden Schritte umfasst:
- Bereitstellen eines Substrats (100), das einer ersten Siliziumschicht (210) auf einer ersten dielektrischen Schicht (110) zugeordnet ist,
- Strukturieren der ersten Siliziumschicht (210), um in der ersten Siliziumschicht (210) wenigstens einen Teil der Dicke eines Wellenleiters (200) und unterschiedliche erste bis fünfte Wellenleiterabschnitte (211, 212, 213, 214, 215) des Wellenleiters zu bilden, die von dem Wellenleiter (200) verschieden sind, wobei der erste bis der fünfte Wellenleiterabschnitt (211, 212, 213, 214, 215) aufeinander folgen und optisch mit dem Wellenleiter (200) durch wenigstens einen von dem ersten und dem fünften Wellenleiterabschnitt (211, 215) verbunden sind,
- Bilden einer ersten und einer zweiten Verdickung (412, 414) aus Silizium, die voneinander durch einen Zwischenraum (413) separiert sind, wobei die erste und die zweite Verdickung (412, 414) und der Zwischenraum (413) gegenüber dem zweiten, dem vierten beziehungsweise dem dritten Wellenleiterabschnitt (212, 214, 213) sind, oder von Zonen der ersten Siliziumschicht (210), die gebildet werden sollen,
- Vergraben von wenigstens der ersten und der zweiten Verdickung (412, 414) aus Silizium durch wenigstens ein dielektrisches Material und Planarisieren des dielektrischen Materials, um eine Zwischenschicht (420) zu bilden, wobei somit eine Gesamtheit Substrat (100)/ erste dielektrische Schicht (110)/ erste Siliziumschicht (210)/ Zwischenschicht (420) gebildet wird,
- Bereitstellen eines Trägers (120),
- Anordnen der Gesamtheit Subtrat (100)/ erste dielektrische Schicht (110)/ erste Siliziumschicht (210)/ Zwiwschenschicht (420) auf dem Träger (120), wobei das Anordnen durch Kleben der Zwischenschicht auf den Träger (120) realisiert wird,
- Entfernen des Substrats (100),
- Bilden einer Verstärkungsstruktur (310), umfassend wenigstens das Verstärkungsmilieu (321), wobei die Verstärkungsstruktur (310) in Kontakt mit der ersten dielektrischen Schicht (110) gebildet wird, wobei ein zentraler Bereich der Verstärkungsstruktur (310) gegenüber dem Zwischenraum (413) präsentiert wird und ein erstes und ein zweites Ende gegenüber der ersten und der zweiten Verdickung (411, 412), derart, dass der zentrale Bereich der Verstärkungsstruktur (310) mit dem Zwischenraum (413) und dem dritten Wellenleiterabschnitt (213) einen Hybridlaserwellenleiter (313) bildet, wobei der zweite und der vierte Wellenleiterabschnitt (212, 214), die erste und die zweite Verdickung (412, 414) aus Silizium, und das erste und das zweite Ende der Verstärkungsstruktur (310) eine erste und eine zweite optische Übergangszone (312, 314) einer optischen Mode zwischen dem Hybridlaserwellenleiter (313) und dem ersten beziehungsweise dem fünften Wellenleiterabschnitt (211, 215) bilden, wobei die photonische Vorrichtung (1) somit gebildet wird,
und wobei ferner eine Gegenreaktionsstruktur (220) gebildet wird, um einen Oszillationshohlraum zu bilden, umfassend wenigstens teilweise das Verstärkungsmilieu, und um somit einen Laser (300) zu bilden, der optisch mit dem Wellenleiter (200) durch wenigstens einen von dem ersten und dem fünften Wellenleiterabschnitt (211, 215) verbunden ist, während wenigstens eines der Schritte aus dem Schritt der Strukturierung der ersten Siliziumschicht (210) und dem Schritt des Bildens der ersten und der zweiten Verdickung (412, 414) aus Silizium.

13. Herstellungsverfahren nach Anspruch 12, wobei der Schritt der Strukturierung der ersten Siliziumschicht (210) vor dem Schritt des Bildens der ersten und der zweiten Verdickung (412, 414) aus Silizium erfolgt.

14. Herstellungsverfahren nach Anspruch 12, wobei der Schritt der Strukturierung der ersten Siliziumschicht (210) nach dem Schritt des Entfernens des Substrats (100) erfolgt, und wobei der Schritt der Strukturierung der ersten Siliziumschicht (210) ein Schritt der Strukturierung der ersten Siliziumschicht (210) und der ersten Schicht aus Dielektrikum (110) ist.

15. Herstellungsverfahren nach einem der Ansprüche 12 bis 14, wobei ferner ein Schritt des Abdünnens der ersten dielektrischen Schicht (110) zwischen dem Schritt des Entfernens des Substrats (100) und der Bildung der Verstärkungsstruktur (310) vorgesehen ist.

16. Verfahren nach einem der Ansprüche 12 bis 15, wobei der Schritt des Bildens der ersten und der zweiten Verdickung (412, 414) aus Silizium ausgewählt ist aus der Gruppe von folgenden Bildungsschritten:
- selektives Abscheiden von Silizium in Kontakt mit der ersten Siliziumschicht, um die erste und die zweite Verdickung (412, 414) aus Silizium zu bilden,
- Abscheiden einer zweiten Siliziumschicht (410) und lokalisiertes Ätzen der zweiten Siliziumschicht (410), um die erste und die zweite Verdickung (412, 414) aus Silizium zu bilden,
- Anordnen einer zweiten Siliziumschicht auf der ersten Siliziumschicht (210) und lokalisiertes Ätzen der zweiten Siliziumschicht (410), um die erste und die zweite Verdickung (412, 414) aus Silizium zu bilden.

17. Herstellungsverfahren nach einem der Ansprüche 12 bis 16, ferner umfassend den folgenden Schritt:
- Bilden wenigstens einer dritten Verdickung (402) aus Silizium, die Teile der ersten Siliziumschicht (210) bedeckt, die strukturiert sind oder strukturiert werden sollen, wobei der dritte Wellenleiterabschnitt (213) von der zusätzlichen Verdickung aus Silzium (201) frei bleibt,
und wobei die wenigstens eine dritte Verdickung (402) aus Silizium Teil des Wellenleiters (200) ist.

## Claims

1. Photonic device (1) comprising:
- a support (120),
- an intermediate layer (420) in contact with the support (120) and comprising at least one dielectric material and a first and second excess thickness of silicon (412, 414), the first and second excess thicknesses of silicon (412, 414) being separated from each other by a space (413),
- a first silicon layer (210) in contact with the intermediate layer (420) opposite the support (120), the first silicon layer (210) comprising at least part of the thickness of a waveguide (200), and first to fifth waveguide sections (211, 212, 213, 214, 215) distinct from the waveguide 200, the first to the fifth waveguide sections (211, 212, 213, 214, 215) succeeding each other and being optically connected to the waveguide (200) by at least either the first or the fifth waveguide section (211, 215), the second, the fourth and the third waveguide sections (212, 214, 213) facing the first and second excess thicknesses (414, 414) and the space (413), respectively,
- a first dielectric layer (110) covering the first silicon layer (210) opposite the intermediate layer (420),
- a gain structure (310) comprising at least one gain medium (321) capable of emitting light, the gain structure (310) having a central portion facing the space (413) and a first and a second end facing the first and the second excess thicknesses (412, 414), thus the central portion of the gain structure (310) with the space (413) and the third waveguide section (213) forms a hybrid laser waveguide, the second and the fourth waveguide sections (212, 214), the first and the second excess thicknesses (412, 414) of silicon and the first and the second ends of the gain structure (310) forming a first and a second optical transition zone (312, 314) of an optical mode between the hybrid laser waveguide (313) and the first and fifth waveguide sections (211, 215) respectively,
- a feedback structure (220) to form an oscillating cavity comprising at least part of the gain medium (321) so as to form a laser (300) optically connected to the waveguide (200) by at least either the first or the fifth waveguide section (211, 215).

2. Photonic device (1) according to claim 1, in which the third waveguide section (213) accommodates a distributed reflector (223) forming the feedback structure (220).

3. Photonic device (1) according to claim 2, in which the distributed reflector (223) is a distributed Bragg grating selected from the group including distributed Bragg gratings with lateral corrugations partially etched in a thickness of the first silicon layer (210), distributed Bragg gratings with lateral corrugations fully etched in the thickness of the first silicon layer (210), distributed Bragg gratings with vertical corrugations partially etched in the thickness of the first silicon layer (210) and distributed Bragg gratings with vertical corrugations fully etched in the thickness of the first silicon layer (210).

4. Photonic device (1) according to claim 3, in which the distributed reflector 223 is selected from the group comprising distributed Bragg gratings with lateral corrugations partially etched in a thickness of the first silicon layer and distributed Bragg gratings with vertical corrugations partially etched in the thickness of the first silicon layer,
and in which the part of the thickness of the first silicon layer (210) in which the corrugations are etched is the part of the thickness of the first silicon layer (210) that is opposite the first dielectric layer (110) and the gain structure (310).

5. Photonic device (1) according to claim 1, in which the first and the fifth waveguide sections (211, 215) accommodate a first and a second mirror (221, 222) respectively so as to form an oscillating cavity comprising the gain medium (321), the first and the second mirrors forming the feedback structure (220).

6. Photonic device (1) according to claim 1, in which the second and the fourth waveguide sections (212, 214) accommodate a first and a second distributed Bragg grating (221, 222) respectively so as to form an oscillating cavity comprising the gain medium (321), the first and the second distributed Bragg gratings forming the feedback structure (220).

7. Photonic device (1) according to claim 1 or 6, in which the first and the second excess thicknesses (411, 414) accommodate a first and a second distributed Bragg grating (221, 222) respectively so as to form an oscillating cavity comprising the gain medium (321), the first and the second distributed Bragg gratings forming the feedback structure (220).

8. Photonic device (1) according to any one of claims 1 to 7, in which the gain structure (310) is chosen from the group comprising gain structures of the "vertical junction" type and gain structures of the "lateral junction" type.

9. Photonic device (1) according to any one of claims 1 to 8, in which the layout of the waveguide (200) is chosen from among:
- a layout with the waveguide (200) entirely in the first silicon layer (210),
- a layout with a first part of the thickness of the waveguide (200) in the first silicon layer (210) and a second part of the thickness of the waveguide (200) in a third excess thickness of silicon (402),
- a layout with a first part of the thickness of the waveguide (200) in the first silicon layer (210) and a second part of the thickness of the waveguide (200) in a fifth excess thickness formed in a material of the gain structure (310).
- a combination of at least two of the above-mentioned layouts.

10. Photonic device (1) according to any one of claims 1 to 9, in which the first waveguide (200) accommodates at least one optical component, the optical component preferably being chosen from the group comprising silicon optical modulators with a PN junction, III-V semiconductor on silicon hybrid modulators, surface coupling gratings, edge couplers, optical filters, wavelength multiplexers and demultiplexers, and photodetectors including germanium on silicon photodetectors and III-V semiconductor on silicon detectors.

11. Photonic device (1) according to any one of claims 1 to 10, in which the first and second excess thicknesses (412, 414) of silicon are each made from a silicon selected from among a monocrystalline silicon, an amorphous silicon and a polycrystalline silicon.

12. Method of fabrication of a photonic device (1) comprising at least one silicon waveguide (200) and a laser (300) comprising a gain medium (321) capable of emitting light, the method comprising the following steps:
- supply a substrate (100) associated with a first silicon layer (210) on a first dielectric layer (110),
- pattern the first silicon layer (210) to form, in the first silicon layer (210), at least part of the thickness of a waveguide (200), and first to fifth waveguide sections (211, 212, 213, 214, 215) distinct from the waveguide (200), the first to the fifth waveguide sections (211, 212, 213, 214, 215) succeeding each other and being optically connected to the waveguide (200) by at least either the first or the fifth waveguide section (211, 215),
- formation of a first and a second excess thickness (412, 414) of silicon separated from each other by a space (413), the first and the second excess thicknesses (412, 414) and the space (413) facing the second, fourth and third waveguide sections (212, 214, 213) respectively or zones of the first silicon layer (210) that will formed its,
- burial of at least the first and second excess thicknesses (412, 414) of silicon by at least one dielectric material and planarisation of said dielectric material to form an intermediate layer (420), an assembly composed of the substrate (100)/ first dielectric layer (110)/first silicon layer (210)/intermediate layer (420) thus being formed,
- supply a support (120),
- assemble the substrate (100)/first dielectric layer (110)/first silicon layer (210)/intermediate layer (420) assembly on the support (120), the assembly being made by bonding the intermediate layer on the support (120),
- eliminate the substrate (100),
- formation of a gain structure (310) comprising at least the gain medium (321), the gain structure (310) being formed in contact with the first dielectric layer (110) and having a central portion of the gain structure facing the space (413) and a first and a second end facing the first and the second excess thicknesses (411, 412), thus the central portion of the gain structure (110) with the space (413) and the third waveguide section (213) forms a hybrid laser waveguide (313), the second and the fourth waveguide sections (212, 214), the first and the second excess thicknesses (412, 414) of silicon and the first and the second ends of the gain structure (310) forming a first and a second optical transition zone (312, 314) of an optical mode between the hybrid laser waveguide (313) and the first and fifth waveguide sections (211, 215) respectively, the photonic device (1) thus being formed,
and in which a feedback structure (220) is also formed to form an oscillating cavity comprising at least partly the gain medium and thus form a laser (300) optically connected to the waveguide (200) by at least one of the first and the fifth waveguide sections (211, 215) during at least one of the steps among the step to pattern the first silicon layer (210) and the step to form the first and the second excess thicknesses (412, 414) of silicon.

13. Fabrication method according to claim 12, in which the patterning step of the first silicon layer (210) is done prior to the step to form the first and second excess thicknesses (412, 414) of silicon.

14. Fabrication method according to claim 12, in which the patterning step of the first silicon layer (210) is done after the step to eliminate the substrate (100) and in which the patterning step of the first silicon layer (210) is a step to pattern the first silicon layer (210) and the first dielectric layer (110).

15. Fabrication method according to any one of claims 12 to 14, in which a step to thin the first dielectric layer (110) is also included between the steps to eliminate the substrate (100) and to form the gain structure (310).

16. Fabrication method according to any one of claims 12 to 15, in which the step to form the first and the second excess thicknesses (412, 414) of silicon is selected from the following group of formation steps:
- selective deposition of silicon in contact with the first silicon layer to form the first and second excess thicknesses (412, 414) of silicon,
- deposition of a second silicon layer (410) and local etching of the second silicon layer (410) to form the first and second excess thicknesses (412, 414) of silicon,
- assembly of a second silicon layer on the first silicon layer (210) and local etching of the second silicon layer (410) to form the first and second excess thicknesses (412, 414) of silicon,

17. Fabrication method according to any one of claims 12 to 16, also comprising the following step:
- formation of at least one third excess thickness (402) of silicon covering parts of the first silicon layer (210) that are patterned or that will be patterned, the third waveguide section (213) not having any additional excess thickness (201) of silicon,
and in which at least one third excess thickness (402) of silicon forms part of the waveguide (200).
